(19) Europäisches Patentamt / European Patent Office / Office européen des brevets

(11) **EP 3 531 644 B1**

(12) **EUROPEAN PATENT SPECIFICATION**

(45) Date of publication and mention
of the grant of the patent:
**23.12.2020 Bulletin 2020/52**

(51) Int Cl.:
*H03F 1/32* *(2006.01)*          *H04L 27/36* *(2006.01)*
*H03F 3/24* *(2006.01)*

(21) Application number: **17898490.2**

(22) Date of filing: **28.02.2017**

(86) International application number:
**PCT/CN2017/075278**

(87) International publication number:
**WO 2018/157321 (07.09.2018 Gazette 2018/36)**

(54) **TRANSMITTER AND DIGITAL PRE-DISTORTION CALIBRATION METHOD**

SENDER UND KALIBRIERUNGSVERFAHREN FÜR DIGITALE VORVERZERRUNG

ÉMETTEUR, ET PROCÉDÉ D'ÉTALONNAGE AVEC PRÉDISTORSION NUMÉRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.08.2019 Bulletin 2019/35**

(73) Proprietor: **Huawei Technologies Co., Ltd.
Longgang District
Shenzhen, Guangdong 518129 (CN)**

(72) Inventors:
• **SERGEY, Bakhurin
Shenzhen
Guangdong 518129 (CN)**
• **DOLGIKH, Dmitry Anatolievich
Shenzhen
Guangdong 518129 (CN)**
• **HUO, Shudong
Shenzhen
Guangdong 518129 (CN)**
• **SHI, Huaping
Shenzhen
Guangdong 518129 (CN)**

(74) Representative: **Maiwald Patent- und
Rechtsanwaltsgesellschaft mbH
Elisenhof
Elisenstraße 3
80335 München (DE)**

(56) References cited:
EP-A1- 1 560 327          CN-A- 101 594 327
CN-A- 102 291 347          CN-A- 102 594 749
US-A1- 2007 241 812          US-A1- 2015 180 519

## Description

## TECHNICAL FIELD

Embodiments of the present invention relate to the field of communications technologies, and in particular, to a transmitter and a digital pre-distortion calibration method.

## BACKGROUND

A digital pre-distortion (Digital Pre-distortion, DPD) calibration technology is a technology frequently used in a transmitter. In the DPD calibration technology, a power amplifier output signal is fed back to a digital domain by using a specific method, then a non-linear characteristic of the power amplifier output signal is calculated by using an adaptive algorithm, and finally, a signal is pre-processed by using a specific method before the signal is converted from the digital domain to an analog domain, so that the pre-processed signal approximately presents an undistorted characteristic relative to a digital baseband signal after passing through a power amplifier, to obtain linear power amplifier output.

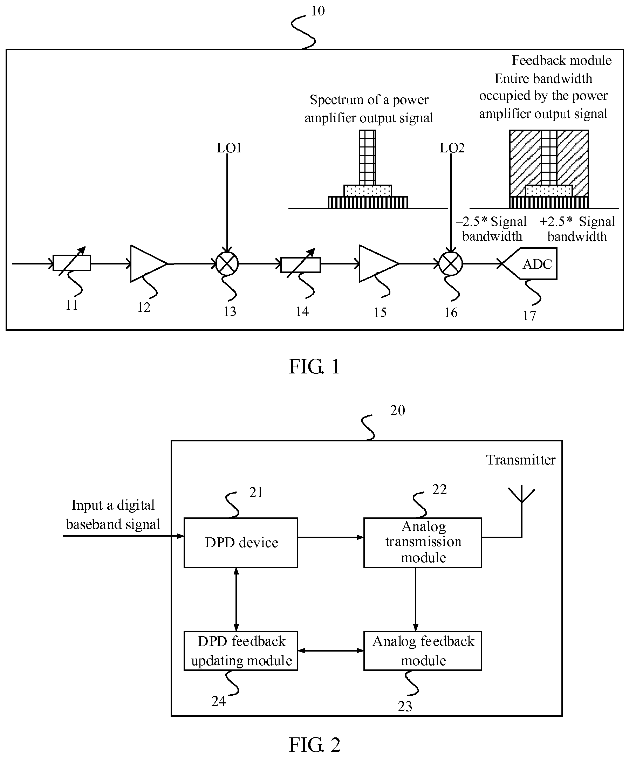

A feedback module in the transmitter is mainly configured to implement signal sampling, to prepare for calculating a non-linear characteristic of a power amplifier output signal. For example, FIG. 1 is a schematic diagram of a feedback module 10 provided in this application. As shown in FIG. 1, a power amplifier output signal is sequentially processed by an attenuator 11, an amplifier 12, a frequency mixer 13, an attenuator 14, an amplifier 15, a frequency mixer 16, and an analog-to-digital converter (Analog-to-Digital Converter, ADC) 17 of the feedback module. The frequency mixer 13 is configured to: obtain a local-frequency signal 1 (Local Oscillator, LO 1), and perform frequency modulation on a received signal based on the LO 1. Similarly, the frequency mixer 16 is configured to: obtain an LO 2, and perform frequency modulation on a received signal based on the LO 2. The ADC can sample a signal. Currently, to accurately calculate the non-linear characteristic of the power amplifier output signal, the ADC 17 needs to perform sampling on an entire bandwidth occupied by the processed power amplifier output signal.

For example, as shown in FIG. 1, the ADC 17 needs to collect a signal on a signal bandwidth of [-2.5, +2.5]. However, when a signal bandwidth of the processed power amplifier output signal is greater than 100 megahertz (Megahertz, MHz), it is difficult for an ADC in a general model to perform signal sampling on the entire bandwidth occupied by the signal. Consequently, the non-linear characteristic of the power amplifier output signal cannot be accurately calculated, and therefore, signal calibration is not accurate enough.

EP 1 560 327 A1 refers to a multi-band look-up table type predistorter.

US 2007 / 0241812 A1 refers to a high efficiency linearization power amplifier for wireless communication.

## SUMMARY

This application provides a transmitter and a digital pre-distortion calibration method, so that a non-linear characteristic of a power amplifier output signal can be accurately calculated, to resolve a problem that signal calibration is not accurate enough.

According to a first aspect, this application provides a transmitter, including:

a DPD device, configured to send a digital baseband signal to an analog transmission module and a DPD feedback updating module;
the analog transmission module, configured to: process the digital baseband signal to obtain an analog signal, and send the analog signal obtained after the processing to an antenna terminal and an analog feedback module that are connected to the analog transmission module;
the analog feedback module, configured to: receive an $i^{th}$ frequency control word sent by the DPD feedback updating module; determine, based on the $i^{th}$ frequency control word, a first center frequency of an $i^{th}$ frequency scan and phase information of an $i^{th}$ sub-spectrum corresponding to the analog signal obtained after the processing; perform, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding first digital signal; and send the first digital signal to the DPD feedback updating module, where the $i^{th}$ frequency scan is a frequency scan performed by the analog feedback module on the $i^{th}$ sub-spectrum corresponding to the analog signal obtained after the processing, i=1, 2, ..., and N, and N is a quantity of sub-spectrums included in a spectrum of the analog signal obtained after the processing; and
the DPD feedback updating module, configured to: determine a second center frequency based on the $i^{th}$ frequency control word, so that the first center frequency is aligned with the second center frequency; process the digital baseband signal based on the second center frequency to obtain a corresponding second digital signal; calculate an error value between the first digital signal and the corresponding second digital signal; determine a DPD coefficient based on error values corresponding to N frequency scans; and send the DPD coefficient to the DPD device.

The DPD device is further configured to: calibrate the digital baseband signal based on the DPD coefficient, and send the calibrated signal to the analog transmission module and the DPD feedback updating module as a new digital baseband signal.

This application has the following beneficial effects: The analog feedback module does not need to perform sampling on an entire bandwidth occupied by the analog signal obtained after the processing, but performs a frequency scan in a segment, and the DPD feedback updating module performs corresponding splicing based on results of frequency scans in segments, to obtain the DPD coefficient. In this way, a non-linear characteristic of a power amplifier output signal can be accurately calculated, to resolve a problem that signal calibration is not accurate enough.

Optionally, the analog transmission module includes: a digital-to-analog converter, configured to: convert the digital baseband signal into an analog baseband signal, and send the analog baseband signal to a first frequency mixer;

a first local oscillator, configured to: generate a local-frequency signal, and send the local-frequency signal to the first frequency mixer;

the first frequency mixer, configured to: perform frequency modulation on the analog baseband signal based on the local-frequency signal, and send the frequency-modulated analog signal to an amplifier; and

the amplifier, configured to: amplify the frequency-modulated analog signal to obtain the analog signal obtained after the processing, and send the analog signal obtained after the processing to an antenna and the analog feedback module that are connected to the analog transmission module.

This application provides the transmitter, which provides a specific structure of the analog transmission module. Based on this, the transmitter can accurately calculate a non-linear characteristic of a power amplifier output signal, to resolve a problem that signal calibration is not accurate enough.

Optionally, the analog feedback module includes: a second local oscillator, configured to: receive the $i^{th}$ frequency control word sent by the DPD feedback updating module; determine, based on the $i^{th}$ frequency control word, the first center frequency and the phase information of the $i^{th}$ sub-spectrum corresponding to the analog signal obtained after the processing; and send, to a second frequency mixer, the first center frequency and the phase information of the $i^{th}$ sub-spectrum corresponding to the analog signal obtained after the processing;

the second frequency mixer, configured to: receive the analog signal obtained after the processing; perform, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding analog signal; and send the corresponding analog signal to a first filter;

the first filter, configured to: perform filtering processing on the corresponding analog signal, and send the analog signal obtained after the filtering processing to an analog-to-digital converter; and

the analog-to-digital converter, configured to: convert the analog signal obtained after the filtering processing into the first digital signal, and send the first digital signal to the DPD feedback updating module.

This application provides the transmitter, which provides a specific structure of the analog feedback module. Based on this, the transmitter can accurately calculate a non-linear characteristic of a power amplifier output signal, to resolve a problem that signal calibration is not accurate enough.

Optionally, the second frequency mixer is specifically configured to: determine the $i^{th}$ sub-spectrum based on the phase information of the $i^{th}$ sub-spectrum corresponding to the analog signal obtained after the processing, and perform frequency modulation on the $i^{th}$ sub-spectrum based on the first center frequency.

Optionally, the DPD feedback updating module includes: a processor, configured to: generate the second center frequency based on the $i^{th}$ frequency control word, and send the second center frequency to a transform unit;

the transform unit, configured to: receive the digital baseband signal; perform Fourier transform on the digital baseband signal based on the second center frequency; perform filtering processing on the Fourier-transformed signal; perform Fourier transform again on the signal obtained after the filtering processing, to obtain the second digital signal; and send the second digital signal to an adder; and

the adder, configured to: calculate the error value between the first digital signal and the corresponding second digital signal, and send, to the processor, the error values corresponding to the N frequency scans.

The processor is further configured to: determine the DPD coefficient based on the error values corresponding to the N frequency scans, and send the DPD coefficient to the DPD device.

This application provides the transmitter, which provides a specific structure and function of the DPD feedback updating module. Based on this, the transmitter can accurately calculate a non-linear characteristic of a power amplifier output signal, to resolve a problem that signal calibration is not accurate enough.

Optionally, the transform unit is specifically configured to:

calculate the second digital signal by using a formula
$$x_i^{'}(k) = (lpf(x(k) * e^{j2\pi f_i(k)}) * (e^{-j2\pi f_i(k)})),$$
where

$x'_i(k)$ represents the second digital signal corresponding to the $i^{th}$ frequency scan in a process of calculating the DPD coefficient for a $k^{th}$ time; $x(k)$ represents the digital baseband signal in the process of calculating the DPD coefficient for the $k^{th}$ time; *lpf* represents a digital low-pass filtering function; and $f_i(k)$ represents the second center frequency in the process of calculating the DPD coefficient for the $k^{th}$ time, where k is a positive integer greater than or equal to 1.

The second digital signal can be accurately calculated based on the formula. Based on this, the transmitter can accurately calculate a non-linear characteristic of a power amplifier output signal, to resolve a problem that signal calibration is not accurate enough.

Optionally, the transform unit includes a third frequency mixer, a second filter, and a fourth frequency mixer.

The third frequency mixer is configured to: receive the digital baseband signal, and perform Fourier transform on the digital baseband signal based on the second center frequency to obtain the Fourier-transformed signal.

The second filter is configured to perform filtering processing on the Fourier-transformed signal.

The fourth frequency mixer is configured to: perform Fourier transform again on the signal obtained after the filtering processing, to obtain the second digital signal; and send the second digital signal to the adder.

This application provides the transmitter, which provides a specific structure of the transform unit. Based on this, the transmitter can accurately calculate a non-linear characteristic of a power amplifier output signal, to resolve a problem that signal calibration is not accurate enough.

Optionally, the processor is specifically configured to:

calculate a total error value by using a formula

$$ err(k) = \sum^{N} ((x_i^{'}(k) - x_i(k)) * e^{j2\pi f_i(k)}) $$

where

$err(k)$ represents the total error value in the process of calculating the DPD coefficient for the $k^{th}$ time; $x'_i(k)$ represents the second digital signal corresponding to the $i^{th}$ frequency scan in the process of calculating the DPD coefficient for the $k^{th}$ time; $x_i(k)$ represents the first digital signal corresponding to the $i^{th}$ frequency scan in the process of calculating the DPD coefficient for the $k^{th}$ time; $x_i^{'}(k) - x_i(k)$ represents the error value corresponding to the $i^{th}$ frequency scan in the process of calculating the DPD coefficient for the $k^{th}$ time; and $f_i(k)$ represents the second center frequency in the process of calculating the DPD coefficient for the $k^{th}$ time, where k is a positive integer greater than or equal to 1; and calculate the DPD coefficient for the $k^{th}$ time by using a formula $a(k) = a(k-1) + \mu^* err(k)\overline{x_i(k)}$, where $a(k)$ represents the DPD coefficient for the $k^{th}$ time; $a(k-1)$ represents a DPD coefficient for a $(k-1)^{th}$ time; $a(0) = 0$; $\mu$ represents an adaptive algorithm updating step; and $\overline{x_i(k)}$ represents a conjugate of $x_i(k)$.

The DPD coefficient can be accurately calculated based on the formula. Based on this, the transmitter can accurately calculate a non-linear characteristic of a power amplifier output signal, to resolve a problem that signal calibration is not accurate enough.

The following provides a digital pre-distortion calibration method, and the method may be performed by the foregoing transmitter. A specific implementation process and a beneficial effect of the method are similar to those in the foregoing embodiment. Details are not described herein again.

According to a second aspect, this application provides a digital pre-distortion calibration method, including:

processing, by a transmitter, a digital baseband signal to obtain an analog signal, and outputting the analog signal obtained after the processing to an antenna terminal of the transmitter;
determining, by the transmitter based on an $i^{th}$ frequency control word, a first center frequency of an $i^{th}$ frequency scan and phase information of an $i^{th}$ sub-spectrum corresponding to the analog signal obtained after the processing; and performing, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding first digital signal, where the $i^{th}$ frequency scan is a frequency scan performed by an analog feedback module on the $i^{th}$ sub-spectrum corresponding to the analog signal obtained after the processing, i=1, 2, ..., and N, and N is a quantity of sub-spectrums included in a spectrum of the analog signal obtained after the processing;
determining, by the transmitter, a second center frequency based on the $i^{th}$ frequency control word, so that the first center frequency is aligned with the second center frequency; and processing the digital baseband signal based on the second center frequency to obtain a corresponding second digital signal; and
calculating, by the transmitter, an error value between the first digital signal and the corresponding second digital signal; determining a DPD coefficient based on error values corresponding to N frequency scans; calibrating the digital baseband signal based on the DPD coefficient; and performing processing, the same as that on the digital baseband signal, on the calibrated signal that is used as a new digital baseband signal.

Optionally, the processing, by a transmitter, a digital baseband signal to obtain an analog signal includes:

converting, by the transmitter, the digital baseband signal into an analog baseband signal;
generating, by the transmitter, a local-frequency signal; and
performing, by the transmitter, frequency modulation on the analog baseband signal based on the local-frequency signal, and amplifying the frequency-modulated analog signal to obtain the analog signal obtained after the processing.

Optionally, the performing, based on the first center frequency and the phase information of the i$^{th}$ sub-spectrum corresponding to the analog signal obtained after the processing, the i$^{th}$ frequency scan on the i$^{th}$ sub-spectrum corresponding to the analog signal obtained after the processing, to obtain a corresponding first digital signal includes:

performing, by the transmitter based on the first center frequency and the phase information of the i$^{th}$ sub-spectrum corresponding to the analog signal obtained after the processing, the i$^{th}$ frequency scan on the i$^{th}$ sub-spectrum corresponding to the analog signal obtained after the processing, to obtain a corresponding analog signal; and
performing, by the transmitter, filtering processing on the corresponding analog signal, and converting the analog signal obtained after the filtering processing into the first digital signal.

Optionally, the performing, by the transmitter based on the first center frequency and the phase information of the i$^{th}$ sub-spectrum corresponding to the analog signal obtained after the processing, the i$^{th}$ frequency scan on the i$^{th}$ sub-spectrum corresponding to the analog signal obtained after the processing includes:

determining, by the transmitter, the i$^{th}$ sub-spectrum based on the phase information of the i$^{th}$ sub-spectrum corresponding to the analog signal obtained after the processing; and
performing, by the transmitter, frequency modulation on the i$^{th}$ sub-spectrum based on the first center frequency.

Optionally, the processing the digital baseband signal based on the second center frequency to obtain a corresponding second digital signal includes:
performing, by the transmitter, Fourier transform on the digital baseband signal based on the second center frequency, performing filtering processing on the Fourier-transformed signal, and performing Fourier transform again on the signal obtained after the filtering processing, to obtain the second digital signal.

Optionally, the performing, by the transmitter, Fourier transform on the digital baseband signal based on the second center frequency, performing filtering processing on the Fourier-transformed signal, and performing Fourier transform again on the signal obtained after the filtering processing, to obtain the second digital signal includes:

calculating, by the transmitter, the second digital signal by using a formula

$$x_i'(k) = (lpf(x(k)*e^{j2\pi f_i(k)})*(e^{-j2\pi f_i(k)})),$$

where

$x'_i(k)$ represents the second digital signal corresponding to the i$^{th}$ frequency scan in a process of calculating the DPD coefficient for a k$^{th}$ time; $x(k)$ represents the digital baseband signal in the process of calculating the DPD coefficient for the k$^{th}$ time; $lpf$ represents a digital low-pass filtering function; and $f_i(k)$ represents the second center frequency in the process of calculating the DPD coefficient for the k$^{th}$ time, where k is a positive integer greater than or equal to 1.

Optionally, the calculating, by the transmitter, an error value between the first digital signal and the corresponding second digital signal, and determining a DPD coefficient based on error values corresponding to N frequency scans includes:

calculating, by the transmitter, a total error value by using a formula

$$err(k) = \sum^{N}((x_i'(k) - x_i(k))*e^{j2\pi f_i(k)})$$

, where

$err(k)$ represents the total error value in the process of calculating the DPD coefficient for the k$^{th}$ time; $x'_i(k)$ represents the second digital signal corresponding to the i$^{th}$ frequency scan in the process of calculating the DPD coefficient for the k$^{th}$ time; $x_i(k)$ represents the first digital signal corresponding to the i$^{th}$ frequency scan in the process of calculating the DPD coefficient for the k$^{th}$ time; $x_i'(k) - x_i(k)$ represents the error value corresponding to the i$^{th}$ frequency scan in the process of calculating the DPD coefficient for the k$^{th}$ time; and $f_i(k)$ represents the second center frequency in the process of calculating the DPD coefficient for the k$^{th}$ time, where k is a positive integer greater than or equal to 1; and calculating, by the transmitter, the DPD coefficient for the k$^{th}$ time by using a formula $a(k) = a(k-1) + \mu * err(k)\overline{x_i(k)}$, where

$a(k)$ represents the DPD coefficient for the k$^{th}$ time;

$a(k-1)$ represents a DPD coefficient for a $(k-1)^{th}$ time; $a(0)=0$; $\mu$ represents an adaptive algorithm updating step; and $\overline{x_i(k)}$ represents a conjugate of $x_i(k)$.

This application provides the transmitter and the digital pre-distortion calibration method. The transmitter includes the digital pre-distortion DPD device, the analog transmission module, the analog feedback module, and the DPD feedback updating module. The DPD device is configured to send the digital baseband signal to the analog transmission module and the DPD feedback updating module. The analog transmission module is configured to: process the digital baseband signal to obtain the analog signal, and send the analog signal obtained after the processing to the antenna terminal and the analog feedback module that are connected to the analog transmission module. The analog feedback module is configured to: receive the $i^{th}$ frequency control word sent by the DPD feedback updating module; determine, based on the $i^{th}$ frequency control word, the first center frequency of the $i^{th}$ frequency scan and the phase information of the $i^{th}$ sub-spectrum corresponding to the analog signal obtained after the processing; perform, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain the corresponding first digital signal; and send the first digital signal to the DPD feedback updating module, where the $i^{th}$ frequency scan is the frequency scan performed by the analog feedback module on the $i^{th}$ sub-spectrum corresponding to the analog signal obtained after the processing, i=1, 2, ..., and N, and N is the quantity of sub-spectrums included in the spectrum of the analog signal obtained after the processing. The DPD feedback updating module is configured to: determine the second center frequency based on the $i^{th}$ frequency control word, so that the first center frequency is aligned with the second center frequency; process the digital baseband signal based on the second center frequency to obtain the corresponding second digital signal; calculate the error value between the first digital signal and the corresponding second digital signal; determine the DPD coefficient based on the error values corresponding to the N frequency scans; and send the DPD coefficient to the DPD device. The DPD device is further configured to: calibrate the digital baseband signal based on the DPD coefficient, and send the calibrated signal to the analog transmission module and the DPD feedback updating module as a new digital baseband signal, so that a non-linear characteristic of a power amplifier output signal can be accurately calculated, to resolve a problem that signal calibration is not accurate enough.

## BRIEF DESCRIPTION OF DRAWINGS

FIG. 1 is a schematic diagram of a feedback module in this application;
FIG. 2 is a schematic diagram of a transmitter according to Embodiment 1 of this application;
FIG. 3 is a schematic diagram of a transmitter according to Embodiment 2 of this application;
FIG. 4 is a schematic diagram of a transmitter according to Embodiment 3 of this application;
FIG. 5 is a schematic diagram of a transmitter according to Embodiment 4 of this application;
FIG. 6 is a schematic diagram of a transmitter according to Embodiment 5 of this application;
FIG. 7 is a schematic flowchart of a digital pre-distortion calibration method according to Embodiment 6 of this application; and
FIG. 8 is a schematic flowchart of a digital pre-distortion calibration method according to Embodiment 7 of this application.

## DESCRIPTION OF EMBODIMENTS

In the prior art, an ADC needs to perform sampling on an entire bandwidth occupied by a processed power amplifier output signal, to accurately calculate a non-linear characteristic of the power amplifier output signal. However, when a signal bandwidth is relatively large, it is difficult for an ADC in a general model to perform signal sampling in the entire bandwidth occupied by the signal. Consequently, the non-linear characteristic of the power amplifier output signal cannot be accurately calculated, and therefore, signal calibration is not accurate enough. To resolve this technical problem, this application provides a transmitter. The transmitter may be a transmitter of network device or user equipment. The transmitter provided in this application is applicable to a system such as a mobile communication network, a fixed radio access network, wireless data transmission, and radar.

### Embodiment 1

FIG. 2 is a schematic diagram of a transmitter according to Embodiment 1 of this application. As shown in FIG. 2, the transmitter 20 includes a DPD device 21, an analog transmission module 22, an analog feedback module 23, and a DPD feedback updating module 24. An arrow in the figure represents a signal flow direction.
The DPD device 21 is configured to send a digital baseband signal to the analog transmission module 22 and the DPD feedback updating module 24.
The analog transmission module 22 is configured to: process the digital baseband signal to obtain an analog signal, and send the analog signal obtained after the processing to an antenna terminal and the analog feedback module 23 that are connected to the analog transmission module 22.

The analog feedback module 23 is configured to: receive an $i^{th}$ frequency control word sent by the DPD feedback updating module 24, and determine, based on the $i^{th}$ frequency control word, a first center frequency of an $i^{th}$ frequency scan and phase information of an $i^{th}$ sub-spectrum corresponding to the analog signal obtained after the processing; perform, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding first digital signal; and send the first digital signal to the DPD feedback updating module 24. The $i^{th}$ frequency scan is a frequency scan performed by the analog feedback module on the $i^{th}$ sub-spectrum corresponding to the analog signal obtained after the processing, i=1, 2, ..., and N, and N is a quantity of sub-spectrums included in a spectrum of the analog signal obtained after the processing.

The DPD feedback updating module 24 is configured to: determine a second center frequency based on the $i^{th}$ frequency control word, so that the first center frequency is aligned with the second center frequency; process the digital baseband signal based on the second center frequency to obtain a corresponding second digital signal; calculate an error value between the first digital signal and the corresponding second digital signal; determine a DPD coefficient based on error values corresponding to N frequency scans; and send the DPD coefficient to the DPD device 21.

The DPD device 21 is further configured to: calibrate the digital baseband signal based on the DPD coefficient, and send the calibrated signal to the analog transmission module 22 and the DPD feedback updating module 24 as a new digital baseband signal.

Optionally, the $i^{th}$ frequency control word may be used to instruct to equally divide the spectrum occupied by the analog signal obtained after the processing into N parts, and the $i^{th}$ frequency control word is a frequency control word corresponding to the $i^{th}$ sub-spectrum. Based on this, if the analog feedback module 23 receives the $i^{th}$ frequency control word, the analog feedback module 23 may determine, based on a bandwidth of the spectrum occupied by the analog signal obtained after the processing, the phase information of the $i^{th}$ sub-spectrum and the first center frequency corresponding to the $i^{th}$ sub-spectrum. For example, a first frequency control word may be used to instruct to equally divide the spectrum occupied by the analog signal obtained after the processing into four parts, and the first frequency control word is a frequency control word corresponding to a first sub-spectrum. It is assumed that the analog feedback module 23 determines that the bandwidth of the spectrum occupied by the analog signal obtained after the processing is [-50 MHz, 50 MHz]. The analog feedback module 23 equally divides the bandwidth with a range of [-50 MHz, 50 MHz] into four parts based on the first frequency control word, namely, [-50 MHz, -25 MHz], [-25 MHz, 0 MHz], [0 MHz, 25 MHz], and [25 MHz, 50 MHz]. Because the first frequency control word is the frequency control word corresponding to the first sub-spectrum, the analog feedback module 23 may determine that phase information of the first sub-spectrum is [-50 MHz, -25 MHz], and determine that a first center frequency of the first sub-spectrum is -37.5 MHz. The analog feedback module 23 may further calculate, by using a same method, phase information corresponding to each of a second to a fourth sub-spectrums and a first center frequency corresponding to each of the second to the fourth sub-spectrums.

Optionally, the $i^{th}$ frequency control word may be used to instruct to divide the spectrum occupied by the analog signal obtained after the processing into the N sub-spectrums, and bandwidths of the N sub-spectrums may form an arithmetic progression, a geometric progression, or the like. In addition, the $i^{th}$ frequency control word is a frequency control word corresponding to the $i^{th}$ sub-spectrum.

It should be noted that regardless of whether the N sub-spectrums have a same bandwidth or different bandwidths, the spectrum occupied by the analog signal obtained after the processing is formed by the N sub-spectrums, and there is no intersection between adjacent sub-spectrums.

Optionally, the transmitter may store phase information of each sub-spectrum in a register.

In the foregoing process, the analog feedback module 23 obtains N first digital signals after performing the N frequency scans. The first digital signals are in a one-to-one correspondence with the sub-spectrums included in the spectrum occupied by the analog signal obtained after the processing.

The spectrum of the analog signal obtained after the processing is the same as a spectrum of the digital baseband signal. Therefore, the second center frequency determined by the DPD feedback updating module 24 based on the $i^{th}$ frequency control word is also the same as the first center frequency. In other words, the first center frequency can be aligned with the second center frequency. In addition, the phase that is of the $i^{th}$ sub-spectrum corresponding to the analog signal obtained after the processing and that is determined by the DPD feedback updating module 24 based on the $i^{th}$ frequency control word is also the same as a phase of the $i^{th}$ sub-spectrum corresponding to the digital baseband signal. In other words, the phase of the $i^{th}$ sub-spectrum corresponding to the analog signal obtained after the processing is aligned, based on the $i^{th}$ frequency control word, with the phase of the $i^{th}$ sub-spectrum corresponding to the digital baseband signal.

The DPD feedback updating module 24 separately determines N corresponding second center frequencies based on a first to an $N^{th}$ frequency control words. Based on this, the DPD feedback updating module 24 processes the digital baseband signal based on the N second center frequencies to obtain N corresponding second digital signals; calculates the error values between the first digital signals and the corresponding second digital signals; determines the DPD coefficient based on the error values corresponding to the N frequency scans; and sends the DPD coefficient to the DPD device 21.

Finally, the DPD device 21 is further configured to: calibrate the digital baseband signal based on the DPD coefficient, and send the calibrated signal to the analog transmission module 22 and the DPD feedback updating module 24 as the new digital baseband signal. A method in which the analog transmission module 22 and the DPD feedback updating module 24 process the new digital baseband signal is the same as the foregoing method for processing the digital baseband signal, and a method in which the analog feedback module 23 processes an analog signal obtained after processing is also the same as the foregoing method for processing the analog signal obtained after the processing. Details are not described herein again.

This application provides the transmitter. The analog feedback module may perform the N frequency scans on the analog signal obtained after the processing to obtain the N corresponding first digital signals. The DPD feedback updating module may perform corresponding processing on the digital baseband signal to obtain the second digital signal. Finally, the DPD feedback updating module may calculate the error value between the first digital signal and the corresponding second digital signal, and determine the DPD coefficient based on the error values corresponding to the N frequency scans, so that the DPD device calibrates the digital baseband signal based on the DPD coefficient. The analog feedback module does not need to perform sampling on the entire bandwidth occupied by the analog signal obtained after the processing, but performs a frequency scan in a segment, and the DPD feedback updating module performs corresponding splicing based on results of frequency scans in segments, to obtain the DPD coefficient. In this way, a non-linear characteristic of a power amplifier output signal can be accurately calculated, to resolve a problem that signal calibration is not accurate enough.

**Embodiment 2**

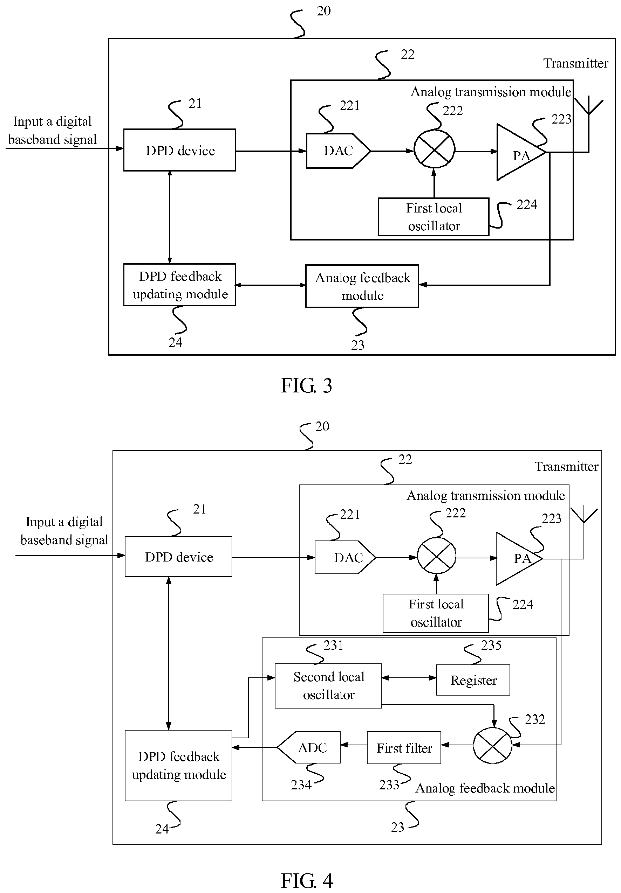

Based on Embodiment 1, the following further refines the analog transmission module 22. Specifically, FIG. 3 is a schematic diagram of a transmitter according to Embodiment 2 of this application. As shown in FIG. 3, the analog transmission module 22 includes a digital-to-analog converter (Digital-to-Analog Converter, DAC) 221, a first frequency mixer 222, an amplifier 223, and a first local oscillator 224.

The digital-to-analog converter 221 is configured to: convert the digital baseband signal into an analog baseband signal, and send the analog baseband signal to the first frequency mixer 222.

The first local oscillator 224 is configured to: generate a local-frequency signal, and send the local-frequency signal to the first frequency mixer 222.

The first frequency mixer 222 is configured to: perform frequency modulation on the analog baseband signal based on the local-frequency signal, and send the frequency-modulated analog signal to the amplifier 223.

The amplifier 223 is configured to: amplify the frequency-modulated analog signal to obtain the analog signal obtained after the processing, and send the analog signal obtained after the processing to an antenna and the analog feedback module 23 that are connected to the analog transmission module 22.

Optionally, the first frequency mixer 222 is specifically configured to adjust the analog baseband signal from a low frequency to a high frequency based on the local-frequency signal.

Optionally, a frequency mixer may be further connected after the amplifier 223. The frequency mixer may also be connected to a local oscillator, so that frequency modulation can be performed, by using a local-frequency signal generated by the local oscillator, on an amplified signal that is output by the amplifier 223. In addition, an amplifier may be further connected after the frequency mixer. The amplifier is configured to amplify the signal obtained after the frequency mixer performs frequency modulation. A quantity of amplifiers and a quantity of local oscillators included in the transmitter are not limited in this application.

This application provides the transmitter, which provides a specific structure of the analog transmission module. Based on this, the transmitter can accurately calculate a non-linear characteristic of a power amplifier output signal, to resolve a problem that signal calibration is not accurate enough.

**Embodiment 3**

Based on Embodiment 1 or Embodiment 2, the following further refines the analog feedback module 23. Embodiment 2 is used as an example. Specifically, FIG. 4 is a schematic diagram of a transmitter according to Embodiment 3 of this application. As shown in FIG. 4, the analog feedback module 23 includes a second local oscillator 231, a second frequency mixer 232, a first filter 233, and an analog-to-digital converter ADC 234.

The second local oscillator 231 is configured to: receive the $i^{th}$ frequency control word sent by the DPD feedback updating module 24; determine, based on the $i^{th}$ frequency control word, the first center frequency and the phase information of the $i^{th}$ sub-spectrum corresponding to the analog signal obtained after the processing; and send, to the second frequency mixer 232, the first center frequency and the phase information of the $i^{th}$ sub-spectrum corresponding to the analog signal obtained after the processing.

The second frequency mixer 232 is configured to: receive the analog signal obtained after the processing; perform, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding analog signal; and send the corresponding analog signal to the first filter 233.

The first filter 233 is configured to: perform filtering processing on the corresponding analog signal, and send the analog signal obtained after the filtering processing to the analog-to-digital converter 234.

The analog-to-digital converter 234 is configured to: convert the analog signal obtained after the filtering processing into the first digital signal, and send the first digital signal to the DPD feedback updating module 24.

Optionally, the $i^{th}$ frequency control word may be used to instruct to equally divide the spectrum occupied by the analog signal obtained after the processing into N parts, and the $i^{th}$ frequency control word is a frequency control word corresponding to the $i^{th}$ sub-spectrum. If the second local oscillator 231 receives the $i^{th}$ frequency control word, the second local oscillator 231 may determine, based on a bandwidth of the spectrum occupied by the analog signal obtained after the processing, the phase information of the $i^{th}$ sub-spectrum and the first center frequency corresponding to the $i^{th}$ sub-spectrum.

Optionally, the $i^{th}$ frequency control word may be used to instruct to divide the spectrum occupied by the analog signal obtained after the processing into the N sub-spectrums, and bandwidths of the N sub-spectrums may form an arithmetic progression, a geometric progression, or the like. In addition, the $i^{th}$ frequency control word is a frequency control word corresponding to the $i^{th}$ sub-spectrum.

Specific method steps in Embodiment 1 may be used in a method in which the second local oscillator 231 determines the first center frequency based on the $i^{th}$ frequency control word. Details are not described herein again. In addition, the second local oscillator 231 and the first local oscillator are based on same reference information.

Optionally, the analog feedback module 23 further includes a register 235, and the register 235 is configured to store phase information of a first to an $N^{th}$ sub-spectrums.

Optionally, the second frequency mixer 232 is specifically configured to: determine the $i^{th}$ sub-spectrum based on the phase information of the $i^{th}$ sub-spectrum corresponding to the analog signal obtained after the processing, and perform frequency modulation on the $i^{th}$ sub-spectrum based on the first center frequency.

Optionally, the first filter 233 may perform filtering processing on the corresponding analog signal by using a low-pass filtering method in the prior art.

This application provides the transmitter, which provides a specific structure of the analog feedback module. Based on this, the transmitter can accurately calculate a non-linear characteristic of a power amplifier output signal, to resolve a problem that signal calibration is not accurate enough.

**Embodiment 4**

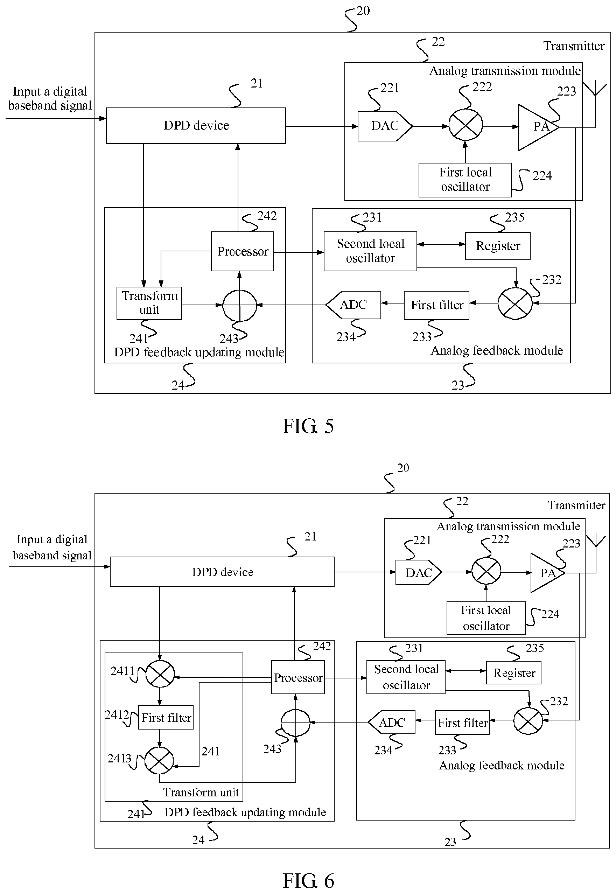

Based on Embodiment 1, Embodiment 2, or Embodiment 3, the following further refines the DPD feedback updating module 24. Embodiment 3 is used as an example. Specifically, FIG. 5 is a schematic diagram of a transmitter according to Embodiment 4 of this application. The DPD feedback updating module 24 includes a transform unit 241, a processor 242, and an adder 243.

The processor 242 is configured to: generate the second center frequency based on the $i^{th}$ frequency control word, and send the second center frequency to the transform unit 241.

The transform unit 241 is configured to: receive the digital baseband signal; perform Fourier transform on the digital baseband signal based on the second center frequency; perform filtering processing on the Fourier-transformed signal; perform Fourier transform again on the signal obtained after the filtering processing, to obtain the second digital signal; and send the second digital signal to the adder 243.

The adder 243 is configured to: calculate the error value between the first digital signal and the corresponding second digital signal, and send, to the processor 242, the error values corresponding to the N frequency scans.

The processor 242 is further configured to: determine the DPD coefficient based on the error values corresponding to the N frequency scans, and send the DPD coefficient to the DPD device 241.

Specifically, the transform unit 241 is specifically configured to:

calculate the second digital signal by using a formula

$$x_i^{'}(k) = (lpf(x(k) * e^{j2\pi f_i(k)}) * (e^{-j2\pi f_i(k)})),$$

where
$x'_i(k)$ represents the second digital signal corresponding to the $i^{th}$ frequency scan in a process of calculating the DPD coefficient for a $k^{th}$ time; $x(k)$ represents the digital baseband signal in the process of calculating the DPD coefficient for the $k^{th}$ time; $lpf$ represents a digital low-pass filtering function, where the digital low-pass filtering function may be any digital low-pass filtering function disclosed in the prior art, and this is not limited in this application; and $f_i(k)$ represents the second center frequency in the process of calculating the DPD coefficient for the $k^{th}$ time, where k is a quantity of times that the DPD coefficient is calculated, and K is a positive integer greater than or equal to 1.

This application provides the transmitter, which provides a specific structure and function of the DPD feedback updating module. Based on this, the transmitter can accurately calculate a non-linear characteristic of a power amplifier output signal, to resolve a problem that signal calibration is not accurate enough.

**Embodiment 5**

Based on Embodiment 4, the following further refines the transform unit 241. Specifically, FIG. 6 is a schematic diagram of a transmitter according to Embodiment 5 of this application. The transform unit 241 includes a third frequency mixer 2411, a second filter 2412, and a fourth frequency mixer 2413.

The third frequency mixer 2411 is configured to: receive the digital baseband signal, and perform Fourier transform on the digital baseband signal based on the second center frequency to obtain the Fourier-transformed signal.

The second filter 2412 is configured to perform filtering processing on the Fourier-transformed signal.

The fourth frequency mixer 2413 is configured to: perform Fourier transform again on the signal obtained after the filtering processing, to obtain the second digital signal; and send the second digital signal to the adder 243.

The second filter 2412 may perform filtering processing by using the foregoing digital low-pass filtering function.

Based on Embodiment 4 or Embodiment 5, further, the processor 242 is specifically configured to:

calculate a total error value by using a formula

$$err(k) = \sum^{N}((x_i^{'}(k) - x_i(k)) * e^{j2\pi f_i(k)})$$

where

$err(k)$ represents the total error value in the process of calculating the DPD coefficient for the $k^{th}$ time;

$x_i^{'}(k)$ $x'_i(k)$ represents the second digital signal corresponding to the $i^{th}$ frequency scan in the process of calculating the DPD coefficient for the $k^{th}$ time; $x_i(k)$ represents the first digital signal corresponding to the $i^{th}$ frequency scan in the process of calculating the DPD coefficient for the $k^{th}$ time; $x_i^{'}(k) - x_i(k)$ represents the error value corresponding to the $i^{th}$ frequency scan in the process of calculating the DPD coefficient for the $k^{th}$ time; and $f_i(k)$ represents the second center frequency in the process of calculating the DPD coefficient for the $k^{th}$ time, where k is a positive integer greater than or equal to 1; and

calculate the DPD coefficient for the $k^{th}$ time by using a formula $a(k) = a(k-1) + \mu * err(k)\overline{x_i(k)}$, where $a(k)$ represents the DPD coefficient for the $k^{th}$ time; $a(k-1)$ represents a DPD coefficient for a $(k-1)^{th}$ time; $a(0) = 0$; $\mu$ represents an adaptive algorithm updating step; and $\overline{x_i(k)}$ represents a conjugate of $x_i(k)$.

Any adaptive algorithm provided in the prior art may be used in this application. This is not limited in this application.

This application provides the transmitter, which provides a specific structure of the transform unit and a specific function of the processor. Based on this, the transmitter can accurately calculate a non-linear characteristic of a power amplifier output signal, to resolve a problem that signal calibration is not accurate enough.

**Embodiment 6**

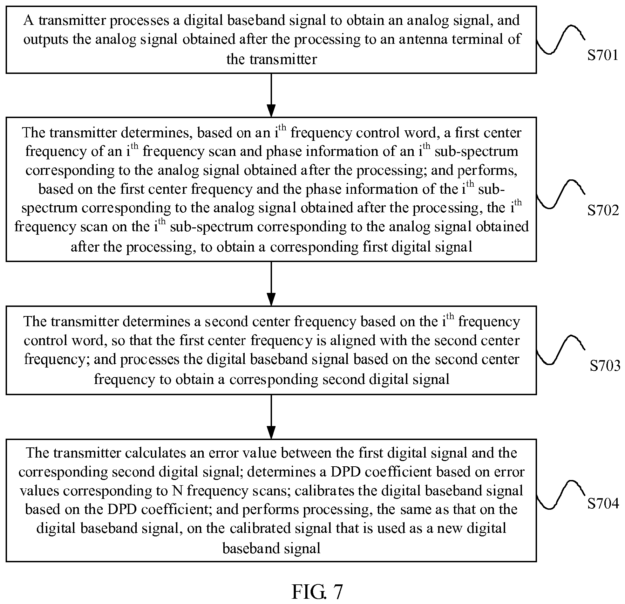

FIG. 7 is a schematic flowchart of a digital predistortion calibration method according to Embodiment 6 of this application. As shown in FIG. 7, the method includes the following steps:

Step S701: A transmitter processes a digital baseband signal to obtain an analog signal, and outputs the analog signal obtained after the processing to an antenna terminal of the transmitter.

Step S702: The transmitter determines, based on an $i^{th}$ frequency control word, a first center frequency of an $i^{th}$ frequency scan and phase information of an $i^{th}$ sub-spectrum corresponding to the analog signal obtained after the processing; and performs, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding first digital signal.

The $i^{th}$ frequency scan is a frequency scan performed by an analog feedback module on the $i^{th}$ sub-spectrum corresponding to the analog signal obtained after the processing, i=1, 2, ..., and N, and N is a quantity of sub-spectrums included in a spectrum of the analog signal obtained after the processing.

Step S703: The transmitter determines a second center frequency based on the $i^{th}$ frequency control word, so that the first center frequency is aligned with the second center frequency; and processes the digital baseband signal based on the second center frequency to obtain a corresponding second digital signal.

Step S704: The transmitter calculates an error value between the first digital signal and the corresponding second digital signal; determines a DPD coefficient based on error values corresponding to N frequency scans; calibrates the digital baseband signal based on the DPD coefficient; and performs processing, the same as that on the digital baseband signal, on the calibrated signal that is used as a new digital baseband signal.

This application provides the digital pre-distortion calibration method, and the method may be performed by the foregoing transmitter. A specific implementation process and a beneficial effect of the method are similar to those in the foregoing embodiment. Details are not described herein again.

**Embodiment 7**

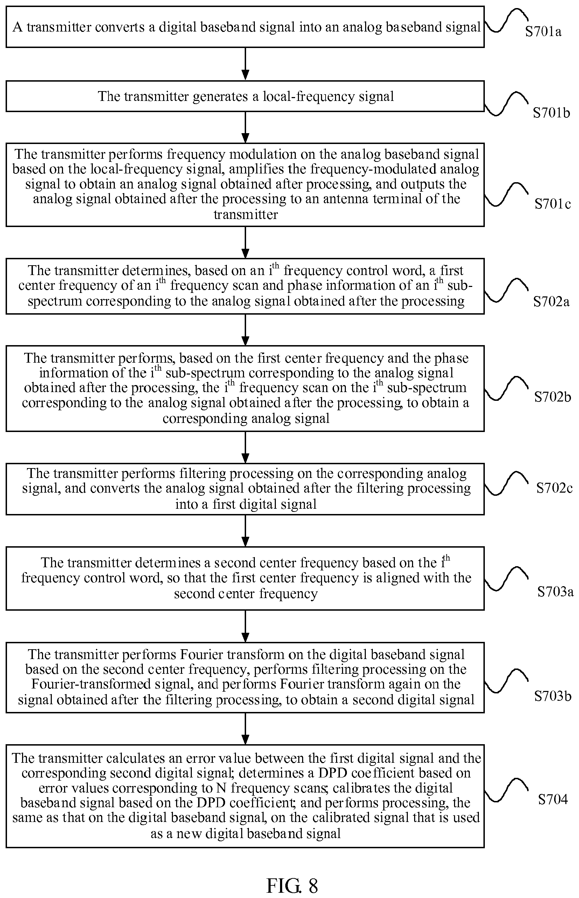

Optionally, FIG. 8 is a schematic flowchart of a digital pre-distortion calibration method according to Embodiment 7 of this application. As shown in FIG. 8, optionally, step S701 specifically includes:

Step S701a: The transmitter converts the digital baseband signal into an analog baseband signal.

Step S701b: The transmitter generates a local-frequency signal.

Step S701c: The transmitter performs frequency modulation on the analog baseband signal based on the local-frequency signal, amplifies the frequency-modulated analog signal to obtain the analog signal obtained after the processing, and outputs the analog signal obtained after the processing to the antenna terminal of the transmitter.

Optionally, step S702 specifically includes:

Step S702a: The transmitter determines, based on the $i^{th}$ frequency control word, the first center frequency of the $i^{th}$ frequency scan and the phase information of the $i^{th}$ sub-spectrum corresponding to the analog signal obtained after the processing.

Step S702b: The transmitter performs, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding analog signal.

Optionally, step S702b specifically includes: The transmitter determines the $i^{th}$ sub-spectrum based on the phase information of the $i^{th}$ sub-spectrum corresponding to the analog signal obtained after the processing, and the transmitter performs frequency modulation on the $i^{th}$ sub-spectrum based on the first center frequency to obtain the corresponding analog signal.

Step S702c: The transmitter performs filtering processing on the corresponding analog signal, and converts the analog signal obtained after the filtering processing into the first digital signal.

Optionally, step S703 specifically includes:

Step S703a: The transmitter determines the second center frequency based on the $i^{th}$ frequency control word, so that the first center frequency is aligned with the second center frequency.

Step S703b: The transmitter performs Fourier transform on the digital baseband signal based on the second center frequency, performs filtering processing on the Fourier-transformed signal, and performs Fourier transform again on the signal obtained after the filtering processing, to obtain the second digital signal.

Optionally, step S703b specifically includes:

calculating, by the transmitter, the second digital signal by using a formula

$$x_i^{'}(k) = (lpf(x(k) * e^{j2\pi f_i(k)}) * (e^{-j2\pi f_i(k)})),$$

where

$x'_i(k)$ represents the second digital signal corresponding to the $i^{th}$ frequency scan in a process of calculating the DPD coefficient for a $k^{th}$ time; $x(k)$ represents the digital baseband signal in the process of calculating the DPD coefficient for the $k^{th}$ time; $lpf$ represents a digital low-pass filtering function; and $f_i(k)$ represents the second center frequency in the process of calculating the DPD coefficient for the $k^{th}$ time, where k is a positive integer greater than or equal to 1.

Optionally, that the transmitter calculates an error value between the first digital signal and the corresponding second digital signal, and determines a DPD coefficient based on error values corresponding to N frequency scans in step S704 includes:

calculating, by the transmitter, a total error value by using a formula

$$err(k) = \sum^{N}((x_i^{'}(k) - x_i(k)) * e^{j2\pi f_i(k)})$$

, where

$err(k)$ represents the total error value in the process of calculating the DPD coefficient for the $k^{th}$ time; $x'_i(k)$ represents the second digital signal corresponding to the $i^{th}$ frequency scan in the process of calculating the DPD coefficient for the $k^{th}$ time; $x_i(k)$ represents the first digital signal corresponding to the $i^{th}$ frequency scan in the process of calculating the DPD coefficient for the $k^{th}$ time; $x_i^{'}(k) - x_i(k)$ represents the error value corresponding to the $i^{th}$ frequency scan in the process of calculating the DPD coefficient for the $k^{th}$ time; and $f_i(k)$ represents the second center frequency in the process of calculating the DPD coefficient for the $k^{th}$ time, where k is a positive integer greater than or equal to 1; and

calculating, by the transmitter, the DPD coefficient for the $k^{th}$ time by using a formula $a(k) = a(k-1) + \mu * err(k)\overline{x_i(k)}$, where

$a(k)$ represents the DPD coefficient for the $k^{th}$ time; $a(k-1)$ represents a DPD coefficient for a $(k-1)^{th}$ time; $a(0) = 0$; $\mu$ represents an adaptive algorithm updating step; and $\overline{x_i(k)}$ represents a conjugate of $x_i(k)$.

This application provides the digital pre-distortion calibration method, and the method may be performed by the foregoing transmitter. A specific implementation process and a beneficial effect of the method are similar to those in the foregoing embodiment. Details are not described herein again.

**Claims**

1. A transmitter (20), comprising a digital pre-distortion DPD device (21), an analog transmission module (22), an analog feedback module (23), and a DPD feedback updating module (24), wherein the DPD feedback updating module (24) is connected to the DPD device (23);

   the DPD device (21) is configured to send a digital baseband signal to the analog transmission module (22) and the DPD feedback updating module (24);

   the analog transmission module (22) is configured to: process the digital baseband signal to obtain an analog signal, and send the analog signal obtained after the processing to an antenna terminal and the analog feedback module (23) that are connected to the analog transmission module (22);

   the analog feedback module (23) is configured to: receive an $i^{th}$ frequency control word sent by the DPD feedback updating module (24); determine, based on the $i^{th}$ frequency control word, a first center frequency of an $i^{th}$ frequency scan and phase information of an $i^{th}$ sub-spectrum corresponding to the analog signal obtained after the processing; perform, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding first digital signal; and send the first digital signal to the DPD feedback updating module (24), wherein the $i^{th}$ frequency scan is a frequency scan performed by the analog feedback module (23) on the $i^{th}$ sub-spectrum corresponding to the analog signal obtained after the processing, i=1, 2, ..., and N, and N is a quantity of sub-spectrums comprised in a spectrum of the analog signal obtained after the processing;

   the DPD feedback updating module (24) is configured to: determine a second center frequency based on the $i^{th}$ frequency control word, so that the first center frequency is aligned with the second center frequency; process the digital baseband signal based on the second center frequency to obtain a corresponding second digital signal; calculate an error value between the first digital signal and the corresponding second digital signal; determine a DPD coefficient based on the error values corresponding to N frequency scans; and send the DPD coefficient to the DPD device (21); and

   the DPD device (21) is further configured to: calibrate the digital baseband signal based on the DPD coefficient, and send the calibrated signal to the analog transmission module (22) and the DPD feedback updating module (24) as a new digital baseband signal.

2. The transmitter (20) according to claim 1, wherein the analog transmission module (22) comprises a digital-to-analog converter (221), a first frequency mixer (222), an amplifier (223), and a first local oscillator (224), wherein

   the digital-to-analog converter (221) is configured to: convert the digital baseband signal into an analog baseband signal, and send the analog baseband signal to the first frequency mixer (222);

   the first local oscillator (224) is configured to: generate a local-frequency signal, and send the local-frequency signal to the first frequency mixer (222);

   the first frequency mixer (222) is configured to: perform frequency modulation on the analog baseband signal based on the local-frequency signal, and send the frequency-modulated analog signal to the amplifier (223); and

   the amplifier (223) is configured to: amplify the frequency-modulated analog signal to obtain the analog signal obtained after the processing, and send the analog signal obtained after the processing to an antenna and the analog feedback module that are connected to the analog transmission module (22).

3. The transmitter (22) according to claim 1 or 2, wherein the analog feedback module (23) comprises a second local oscillator (231), a second frequency mixer (232), a first filter (233), and an analog-to-digital converter (234), wherein

   the second local oscillator (231) is configured to: receive the $i^{th}$ frequency control word sent by the DPD feedback updating module (24); determine, based on the $i^{th}$ frequency control word, the first center frequency and the phase information of the $i^{th}$ sub-spectrum corresponding to the analog signal obtained after the processing; and send, to the second frequency mixer (232), the first center frequency and the phase information of the $i^{th}$ sub-spectrum corresponding to the analog signal obtained after the processing;

   the second frequency mixer (232) is configured to: receive the analog signal obtained after the processing; perform, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding analog signal; and send the corresponding analog signal to the first filter (233);

the first filter (233) is configured to: perform filtering processing on the corresponding analog signal, and send the analog signal obtained after the filtering processing to the analog-to-digital converter (234); and

the analog-to-digital converter (234) is configured to: convert the analog signal obtained after the filtering processing into the first digital signal, and send the first digital signal to the DPD feedback updating module (24).

4. The transmitter (20) according to claim 3, wherein the second frequency mixer (232) is specifically configured to:

determine the $i^{th}$ sub-spectrum based on the phase information of the $i^{th}$ sub-spectrum corresponding to the analog signal obtained after the processing; and

perform frequency modulation on the $i^{th}$ sub-spectrum based on the first center frequency.

5. The transmitter (20) according to any one of claims 1 to 4, wherein the DPD feedback updating module (24) comprises a transform unit (241), a processor (242), and an adder (243), wherein

the processor (242) is configured to: generate the second center frequency based on the $i^{th}$ frequency control word, and send the second center frequency to the transform unit (241);

the transform unit (241) is configured to: receive the digital baseband signal; perform Fourier transform on the digital baseband signal based on the second center frequency; perform filtering processing on the Fourier-transformed signal; perform Fourier transform again on the signal obtained after the filtering processing, to obtain the second digital signal; and send the second digital signal to the adder (243);

the adder (243) is configured to: calculate the error value between the first digital signal and the corresponding second digital signal, and send, to the processor (242), the error values corresponding to the N frequency scans; and

the processor (242) is further configured to: determine the DPD coefficient based on the error values corresponding to the N frequency scans, and send the DPD coefficient to the DPD device (21).

6. The transmitter (20) according to claim 5, wherein the transform unit (241) is specifically configured to: calculate the second digital signal by using a formula

$$x_i^{'}(k) = (lpf(x(k) * e^{j2\pi f_i(k)}) * (e^{-j2\pi f_i(k)})) ,$$

wherein

$x'_i(k)$ represents the second digital signal corresponding to the $i^{th}$ frequency scan in a process of calculating the DPD coefficient for a $k^{th}$ time; $x(k)$ represents the digital baseband signal in the process of calculating the DPD coefficient for the $k^{th}$ time; $lpf$ represents a digital low-pass filtering function; and $f_i(k)$ represents the second center frequency in the process of calculating the DPD coefficient for the $k^{th}$ time, wherein k is a positive integer greater than or equal to 1.

7. The transmitter (20) according to claim 5 or 6, wherein the transform unit (241) comprises a third frequency mixer (2411), a second filter (2412), and a fourth frequency mixer (2413), wherein

the third frequency mixer (2411) is configured to: receive the digital baseband signal, and perform Fourier transform on the digital baseband signal based on the second center frequency to obtain the Fourier-transformed signal;

the second filter (2412) is configured to perform filtering processing on the Fourier-transformed signal; and

the fourth frequency mixer (2413) is configured to: perform Fourier transform again on the signal obtained after the filtering processing, to obtain the second digital signal; and send the second digital signal to the adder (243).

8. The transmitter (20) according to any one of claims 5 to 7, wherein the processor (242) is specifically configured to:

calculate a total error value by using a formula

$$err(k) = \sum^{N}((x_i^{'}(k) - x_i(k)) * e^{j2\pi f_i(k)}) , ,$$

wherein

$err(k)$ represents the total error value in the process of calculating the DPD coefficient for the $k^{th}$ time; $x'_i(k)$ represents the second digital signal corresponding to the $i^{th}$ frequency scan in the process of calculating the DPD coefficient for the $k^{th}$ time; $x_i(k)$ represents the first digital signal corresponding to the $i^{th}$ frequency scan in the process of calculating the DPD coefficient for the $k^{th}$ time; $x_i^{'}(k) - x_i(k)$ represents the error value corresponding to the $i^{th}$ frequency scan in the process of calculating the DPD coefficient for the $k^{th}$ time; and $f_i(k)$ represents the second center frequency in the process of calculating the DPD coefficient for the $k^{th}$ time, wherein k is a positive integer greater than or equal to 1; and calculate the DPD coefficient for the $k^{th}$ time by using a formula $a(k) = a(k-1) + \mu * err(k)\overline{x_i(k)}$, wherein

$a(k)$ represents the DPD coefficient for the $k^{th}$ time; $a(k-1)$ represents a DPD coefficient for a $(k-1)^{th}$ time; $a(0) = 0$; $\mu$ represents an adaptive algorithm updating step; and $\overline{x_i(k)}$ represents a conjugate of $x_i(k)$.

9. A digital pre-distortion calibration method, comprising:

Processing (S701), by a transmitter, a digital baseband signal to obtain an analog signal, and outputting the analog signal obtained after the processing to an antenna terminal of the transmitter;
Determining (S702), by the transmitter based on an $i^{th}$ frequency control word, a first center frequency of an $i^{th}$ frequency scan and phase information of an $i^{th}$ sub-spectrum corresponding to the analog signal obtained after the processing; and performing, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding first digital signal, wherein the $i^{th}$ frequency scan is a frequency scan performed by the analog feedback module on the $i^{th}$ sub-spectrum corresponding to the analog signal obtained after the processing, i=1, 2, ..., and N, and N is a quantity of sub-spectrums comprised in a spectrum of the analog signal obtained after the processing;
Determining (S703), by the transmitter, a second center frequency based on the $i^{th}$ frequency control word, so that the first center frequency is aligned with the second center frequency; and processing the digital baseband signal based on the second center frequency to obtain a corresponding second digital signal; and
Calculating (S704), by the transmitter, an error value between the first digital signal and the corresponding second digital signal; determining a DPD coefficient based on the error values corresponding to N frequency scans; calibrating the digital baseband signal based on the DPD coefficient; and performing processing, the same as that on the digital baseband signal, on the calibrated signal that is used as a new digital baseband signal.

10. The method according to claim 9, wherein the processing (S701), by a transmitter, a digital baseband signal to obtain an analog signal comprises:

Converting (S701a), by the transmitter, the digital baseband signal into an analog baseband signal;
Generating (S701b), by the transmitter, a local-frequency signal; and
Performing (S701c), by the transmitter, frequency modulation on the analog baseband signal based on the local-frequency signal, and amplifying the frequency-modulated analog signal to obtain the analog signal obtained after the processing.

11. The method according to claim 9 or 10, wherein the performing (S701c), based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding first digital signal comprises:

Performing (S702b), by the transmitter based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding analog signal; and
Performing (S702c), by the transmitter, filtering processing on the corresponding analog signal, and converting the analog signal obtained after the filtering processing into the first digital signal.

12. The method according to claim 11, wherein the performing, by the transmitter based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing comprises:

determining, by the transmitter, the $i^{th}$ sub-spectrum based on the phase information of the $i^{th}$ sub-spectrum corresponding to the analog signal obtained after the processing; and
performing, by the transmitter, frequency modulation on the $i^{th}$ sub-spectrum based on the first center frequency.

13. The method according to any one of claims 9 to 12, wherein the processing the digital baseband signal based on the second center frequency to obtain a corresponding second digital signal comprises:

Performing (S703b), by the transmitter, Fourier transform on the digital baseband signal based on the second center frequency, performing filtering processing on the Fourier-transformed signal, and performing Fourier transform again on the signal obtained after the filtering processing, to obtain the second digital signal.

14. The method according to claim 13, wherein the performing, by the transmitter, Fourier transform on the digital baseband signal based on the second center frequency, performing filtering processing on the Fourier-transformed signal, and performing Fourier transform again on the signal obtained after the filtering processing, to obtain the second digital signal comprises:

Calculating, by the transmitter, the second digital signal by using a formula

$$x_i^{'}(k) = (lpf(x(k) * e^{j2\pi f_i(k)}) * (e^{-j2\pi f_i(k)})),$$

wherein

$x'_i(k)$ represents the second digital signal corresponding to the $i^{th}$ frequency scan in a process of calculating the DPD coefficient for a $k^{th}$ time; $x(k)$ represents the digital baseband signal in the process of calculating the DPD coefficient for the $k^{th}$ time; $lpf$ represents a digital low-pass filtering function; and $f_i(k)$ represents the second center frequency in the process of calculating the DPD coefficient for the $k^{th}$ time, wherein k is a positive integer greater than or equal to 1.

15. The method according to any one of claims 9 to 14, wherein the calculating, by the transmitter, an error value between the first digital signal and the corresponding second digital signal, and determining a DPD coefficient based on the error values corresponding to N frequency scans comprises:

calculating, by the transmitter, a total error value by using a formula

$$err(k) = \sum^{N} ((x_i^{'}(k) - x_i(k)) * e^{j2\pi f_i(k)}),$$

wherein

$err(k)$ represents the total error value in the process of calculating the DPD coefficient for the $k^{th}$ time; $x'_i(k)$ represents the second digital signal corresponding to the $i^{th}$ frequency scan in the process of calculating the DPD coefficient for the $k^{th}$ time; $x_i(k)$ represents the first digital signal corresponding to the $i^{th}$ frequency scan in the process of calculating the DPD coefficient for the $k^{th}$ time; $x_i^{'}(k) - x_i(k)$ represents the error value corresponding to the $i^{th}$ frequency scan in the process of calculating the DPD coefficient for the $k^{th}$ time; and $f_i(k)$ represents the second center frequency in the process of calculating the DPD coefficient for the $k^{th}$ time, wherein k is a positive integer greater than or equal to 1; and calculating, by the transmitter, the DPD coefficient for the $k^{th}$ time by using a formula $a(k) = a(k-1) + \mu * err(k)\overline{x_i(k)}$, wherein

$a(k)$ represents the DPD coefficient for the $k^{th}$ time; $a(k-1)$ represents a DPD coefficient for a $(k-1)^{th}$ time; $a(0) = 0$; $\mu$ represents an adaptive algorithm updating step; and $\overline{x_i(k)}$ represents a conjugate of $x_i(k)$.

**Patentansprüche**

1. Sender (20), umfassend ein digitales Vorverzerrungs-DPD-Gerät (21), ein analoges Übertragungsmodul (22), ein analoges Rückkopplungsmodul (23) und ein DPD-Rückkopplungs-Aktualisierungsmodul (24), wobei das DPD-Rückkopplungs-Aktualisierungsmodul (24) mit dem DPD-Gerät (23) verbunden ist;

wobei das DPD-Gerät (21) dafür konfiguriert ist, ein digitales Basisbandsignal an das analoge Übertragungsmodul (22) und das DPD-Rückkopplungs-Aktualisierungsmodul (24) zu senden;

wobei das analoge Übertragungsmodul (22) für Folgendes konfiguriert ist:

Verarbeiten des digitalen Basisbandsignals, um ein analoges Signal zu erhalten, und Senden des nach der Verarbeitung erhaltenen analogen Signals an einen Antennenanschluss und an das analoge Rückkopplungsmodul (23), die mit dem analogen Übertragungsmodul (22) verbunden sind;

wobei das analoge Rückkopplungsmodul (23) für Folgendes konfiguriert ist:

Empfangen eines i-ten Frequenz-Steuerworts, das vom DPD-Rückkopplungs-Aktualisierungsmodul (24) gesendet wird;

Bestimmen, basierend auf dem i-ten Frequenz-Steuerwort, einer ersten Mittenfrequenz einer i-ten Frequenzabtastung und der Phaseninformation eines i-ten Teilspektrums, das dem nach der Verarbeitung erhaltenen Analogsignal entspricht;

Durchführen, basierend auf der ersten Mittenfrequenz und der Phaseninformation des i-ten Teilspektrums, das dem nach der Verarbeitung erhaltenen Analogsignal entspricht, der i-ten Frequenzabtastung auf dem i-ten Teilspektrum, das dem nach der Verarbeitung erhaltenen Analogsignal entspricht, um ein entsprechendes erstes digitales Signal zu erhalten; und

Senden des ersten digitalen Signals an das DPD-Rückkopplungs-Aktualisierungsmodul (24), wobei die i-te Frequenzabtastung eine Frequenzabtastung ist, die vom analogen Rückkopplungsmodul (23) an dem i-ten Teilspektrum durchgeführt wird, das dem nach der Verarbeitung erhaltenen analogen Signal entspricht, wobei i = 1, 2, ..., und N, und N eine Menge von Teilspektren ist, die in einem Spektrum des nach der Verarbeitung erhaltenen analogen Signals enthalten sind;

wobei das DPD Rückkopplungs-Aktualisierungsmodul (24) für Folgendes konfiguriert ist: Bestimmen einer zweiten Mittenfrequenz basierend auf dem i-ten Frequenz-Steuerwort, sodass die erste Mittenfrequenz mit der zweiten Mittenfrequenz ausgerichtet ist;

Verarbeiten des digitalen Basisbandsignals basierend auf der zweiten Mittenfrequenz, um ein entsprechendes zweites digitales Signal zu erhalten;

Berechnen eines Fehlerwertes zwischen dem ersten und dem entsprechenden zweiten digitalen Signal;

Bestimmen eines DPD-Koeffizienten basierend auf den Fehlerwerten, die N Frequenzabtastungen entsprechen; und

Senden des DPD-Koeffizienten an das DPD-Gerät (21); und

wobei das DPD-Gerät (21) ferner für Folgendes konfiguriert ist: Kalibrieren des digitalen Basisbandsignals basierend auf dem DPD-Koeffizienten und Senden des kalibrierten Signals an das analoge Übertragungsmodul (22) und das DPD-Rückkopplungs-Aktualisierungsmodul (24) als ein neues digitales Basisbandsignal.

2. Sender (20) nach Anspruch 1, wobei das analoge Übertragungsmodul (22) einen Digital/Analog-Wandler (221), einen ersten Frequenzmischer (222), einen Verstärker (223) und einen ersten lokalen Oszillator (224) umfasst, wobei der Digital/Analog-Wandler (221) für Folgendes konfiguriert ist:

Umwandeln des digitalen Basisbandsignals in ein analoges Basisbandsignal und Senden des analogen Basisbandsignals an den ersten Frequenzmischer (222);

wobei der erste lokale Oszillator (224) für Folgendes konfiguriert ist:

Erzeugen eines Lokalfrequenzsignals und Senden des Lokalfrequenzsignals an den ersten Frequenzmischer (222);

wobei der erste Frequenzmischer (222) für Folgendes konfiguriert ist:

Durchführen einer Frequenzmodulation des analogen Basisbandsignals basierend auf dem Lokalfrequenzsignal und Senden des frequenzmodulierten Analogsignals an den Verstärker (223); und

wobei der Verstärker (223) für Folgendes konfiguriert ist:

Verstärken des frequenzmodulierten Analogsignals, um das nach der Verarbeitung erhaltene Analogsignal zu erhalten, und Senden des nach der Verarbeitung erhaltenen Analogsignals an eine Antenne und an das analoge Rückkopplungsmodul, die mit dem analogen Übertragungsmodul (22) verbunden sind.

3. Sender (22) nach Anspruch 1 oder 2, wobei das analoge Rückkopplungsmodul (23) einen zweiten lokalen Oszillator (231), einen zweiten Frequenzmischer (232), ein erstes Filter (233) und einen Analog-Digital-Wandler (234) umfasst, wobei der zweite lokale Oszillator (231) für Folgendes konfiguriert ist:

Empfangen des i-ten Frequenz-Steuerworts, das vom DPD-Rückkopplungs-Aktualisierungsmodul (24) gesendet wird;

Bestimmen, basierend auf dem i-ten Frequenz-Steuerwort, der ersten Mittenfrequenz und der Phaseninformation des i-ten Teilspektrums, das dem nach der Verarbeitung erhaltenen Analogsignal entspricht; und

Senden, an den zweiten Frequenzmischer (232), der ersten Mittenfrequenz und der Phaseninformation des i-ten Teilspektrums, das dem nach der Verarbeitung erhaltenen Analogsignal entspricht;

wobei der zweite Frequenzmischer (232) für Folgendes konfiguriert ist:

Empfangen des nach der Verarbeitung erhaltenen Analogsignals;

Durchführen, basierend auf der ersten Mittenfrequenz und der Phaseninformation des i-ten Teilspektrums, das dem nach der Verarbeitung erhaltenen Analogsignal entspricht, der i-ten Frequenzabtastung auf dem i-ten Teilspektrum, das dem nach der Verarbeitung erhaltenen Analogsignal entspricht, um ein entsprechendes Analogsignal zu erhalten; und Senden des entsprechenden Analogsignals an das erste Filter (233); wobei das erste Filter (233) für Folgendes konfiguriert ist:

Durchführen einer Filterverarbeitung des entsprechenden Analogsignals und Senden des nach der Filterverarbeitung erhaltenen Analogsignals an den Analog-Digital-Wandler (234); und wobei der Analog-Digital-Wandler (234) für Folgendes konfiguriert ist: Umwandeln des nach der Verarbeitung des Filters erhaltenen Analogsignals in das erste digitale Signal und Senden des ersten digitalen Signals an das DPD-Rückkopplungs-Aktualisierungsmodul (24).

4. Sender (20) nach Anspruch 3, wobei der zweite Frequenzmischer (232) speziell für Folgendes konfiguriert ist:
Bestimmen des i-ten Teilspektrums basierend auf der Phaseninformation des i-ten Teilspektrums, das dem nach der Verarbeitung erhaltenen Analogsignal entspricht; und Durchführen einer Frequenzmodulation des i-ten Teilspektrums basierend auf der ersten Mittenfrequenz.

5. Sender (20) nach einem der Ansprüche 1 bis 4, wobei das DPD-Rückkopplungs-Aktualisierungsmodul (24) eine Transformationseinheit (241), einen Prozessor (242) und einen Addierer (243) umfasst, wobei der Prozessor (242) für Folgendes konfiguriert ist:

Erzeugen der zweiten Mittenfrequenz basierend auf dem i-ten Frequenz-Steuerwort und Senden der zweiten Mittenfrequenz an die Transformationseinheit (241);
wobei die Transformationseinheit (241) für Folgendes konfiguriert ist:

Empfangen des digitalen Basisbandsignals;
Durchführen einer Fourier-Transformation des digitalen Basisbandsignals basierend auf der zweiten Mittenfrequenz;
Durchführen der Filterverarbeitung an dem fourier-transformierten Signal;
Erneutes Durchführen einer Fourier-Transformation an dem nach der Filterverarbeitung erhaltenen Signal, um das zweite digitale Signal zu erhalten; und
Senden des zweiten digitalen Signals an den Addierer (243);
wobei der Addierer (243) für Folgendes konfiguriert ist:

Berechnen des Fehlerwertes zwischen dem ersten und dem entsprechenden zweiten digitalen Signal und Senden der Fehlerwerte, die den N Frequenzabtastungen entsprechen, an den Prozessor (242); und
wobei der Prozessor (242) ferner für Folgendes konfiguriert ist:
Bestimmen des DPD-Koeffizienten basierend auf den Fehlerwerten, die den N Frequenzabtastungen entsprechen, und Senden des DPD-Koeffizienten an das DPD-Gerät (21).

6. Sender (20) nach Anspruch 5, wobei die Transformationseinheit (241) speziell für Folgendes konfiguriert ist:
Berechnen des zweiten digitalen Signals mit Hilfe einer Formel $x'_i(k) = (lpf(x(k) * e^{j2\pi f_i(k)}) * e^{-j2\pi f_i(k)}$, wobei

$x'_i(k)$ für das zweite digitale Signal steht, das der i-ten Frequenzabtastung in einem Prozess zur Berechnung des DPD-Koeffizienten zum k-ten Mal entspricht;
$x(k)$ für das digitale Basisbandsignal beim Prozess zum Berechnen des DPD-Koeffizienten zum k-ten Mal steht;
$lpf$ für eine digitale Tiefpassfilterfunktion steht; und
$f_i(k)$ für die zweite Mittenfrequenz beim Prozess zum Berechnen des DPD-Koeffizienten zum k-ten Mal steht, wobei k eine positive ganze Zahl größer oder gleich 1 ist.

7. Sender (20) nach Anspruch 5 oder 6, wobei die Transformationseinheit (241) einen dritten Frequenzmischer (2411), ein zweites Filter (2412) und einen vierten Frequenzmischer (2413) umfasst, wobei der dritte Frequenzmischer (2411) für Folgendes konfiguriert ist:

Empfangen des digitalen Basisbandsignals und Durchführen einer Fourier-Transformation am digitalen Basisbandsignal basierend auf der zweiten Mittenfrequenz, um das fouriertransformierte Signal zu erhalten;
wobei das zweite Filter (2412) dafür konfiguriert ist, eine Filterverarbeitung an dem fourier-transformierten Signal durchzuführen; und
wobei der vierte Frequenzmischer (2413) für Folgendes konfiguriert ist:

Erneutes Durchführen einer Fourier-Transformation an dem nach der Filterverarbeitung erhaltenen Signal, um das zweite digitale Signal zu erhalten; und
Senden des zweiten digitalen Signals an den Addierer (243).

**8.** Sender (20) nach einem der Ansprüche 5 bis 7, wobei der Prozessor (242) speziell für Folgendes konfiguriert ist:

Berechnen eines Gesamtfehlerwertes mit Hilfe einer Formel

$$err(k) = \sum^{N}((x_i'(\mathrm{k}) - x_i(\mathrm{k})) * e^{j2\pi f_i(k)},$$

wobei

*err(k)* für den Gesamtfehlerwert beim Prozess zum Berechnen des DPD-Koeffizienten zum k-ten Mal steht;

*x'ᵢ(k)* für das zweite digitale Signal steht, das der i-ten Frequenzabtastung beim Prozess zum Berechnen des DPD-Koeffizienten zum k-ten Mal entspricht;

*xᵢ(k)* für das erste digitale Signal steht, das der i-ten Frequenzabtastung beim Prozess zum Berechnen des DPD-Koeffizienten zum k-ten Mal entspricht;

*x'ᵢ(k) - xᵢ(k)* für den Fehlerwert steht, der der i-ten Frequenzabtastung beim Prozess zum Berechnen des DPD-Koeffizienten zum k-ten Mal entspricht; und

*fᵢ(k)* für die zweite Mittenfrequenz beim Prozess zum Berechnen des DPD-Koeffizienten zum k-ten Mal steht, wobei k eine positive ganze Zahl größer oder gleich 1 ist; und

Berechnen des DPD-Koeffizienten zum k-ten Mal mit Hilfe einer Formel

$$a(k) = a(k-1) + \mu * err(k)\overline{x_i(k)},$$ wobei

*a(k)* für den DPD-Koeffizienten zum k-ten Mal steht;

*a(k-1)* für einen DPD-Koeffizienten zum (k-1)-ten Mal steht;

a(0)=0;

$\mu$ für einen adaptiven Algorithmus-Aktualisierungsschritt steht; und

$\overline{x_i(k)}$ für ein Konjugat von *xᵢ(k)* steht.

**9.** Digitales Vorverzerrungs-Kalibrierverfahren, Folgendes umfassend:

Verarbeiten (S701), durch einen Sender, eines digitalen Basisbandsignals, um ein analoges Signal zu erhalten, und Ausgeben des nach der Verarbeitung erhaltenen analogen Signals an einen Antennenanschluss des Senders;
Bestimmen (S702), durch den Sender basierend auf einem i-ten Frequenz-Steuerwort, einer ersten Mittenfrequenz einer i-ten Frequenzabtastung und der Phaseninformation eines i-ten Teilspektrums, das dem nach der Verarbeitung erhaltenen Analogsignal entspricht; und
Durchführen, basierend auf der ersten Mittenfrequenz und der Phaseninformation des i-ten Teilspektrums entsprechend dem nach der Verarbeitung erhaltenen Analogsignal, der i-ten Frequenzabtastung auf dem i-ten Teilspektrum entsprechend dem nach der Verarbeitung erhaltenen Analogsignal, um ein entsprechendes erstes Digitalsignal zu erhalten, wobei die i-te Frequenzabtastung eine Frequenzabtastung ist, die durch das analoge Rückkopplungsmodul auf dem i-ten Teilspektrum entsprechend dem nach der Verarbeitung erhaltenen Analogsignal durchgeführt wird, wobei i=1, 2, ...., und N, und N eine Menge von Teilspektren ist, die in einem Spektrum des nach der Verarbeitung erhaltenen analogen Signals enthalten sind;
Bestimmen (S703), durch den Sender, einer zweiten Mittenfrequenz basierend auf dem i-ten Frequenz-Steuerwort, sodass die erste Mittenfrequenz mit der zweiten Mittenfrequenz ausgerichtet ist; und
Verarbeiten des digitalen Basisbandsignals basierend auf der zweiten Mittenfrequenz, um ein entsprechendes zweites digitales Signal zu erhalten; und
Berechnen (S704), durch den Sender, eines Fehlerwertes zwischen dem ersten digitalen Signal und dem entsprechenden zweiten digitalen Signal;
Bestimmen eines DPD-Koeffizienten basierend auf den Fehlerwerten, die N Frequenzabtastungen entsprechen;
Kalibrieren des digitalen Basisbandsignals basierend auf dem DPD-Koeffizienten; und Durchführen einer Verarbeitung, die der des digitalen Basisbandsignals entspricht, für das kalibrierte Signal, das als neues digitales Basisbandsignal verwendet wird.

**10.** Verfahren nach Anspruch 9, wobei das Verarbeiten (S701), durch einen Sender, eines digitalen Basisbandsignals, um ein analoges Signal zu erhalten, Folgendes umfasst:

Umwandeln (S701a), durch den Sender, des digitalen Basisbandsignals in ein analoges Basisbandsignal;
Erzeugen (S701b), durch den Sender, eines Lokalfrequenzsignals; und
Durchführen (S701c), durch den Sender, einer Frequenzmodulation auf dem analogen Basisbandsignal basierend auf dem Lokalfrequenzsignal und Verstärken des frequenzmodulierten Analogsignals, um das nach der Verarbeitung erhaltene Analogsignal zu erhalten.

**11.** Verfahren nach Anspruch 9 oder 10, wobei das Durchführen (S701c), basierend auf der ersten Mittenfrequenz und der Phaseninformation des i-ten Teilspektrums, das dem nach der Verarbeitung erhaltenen analogen Signal entspricht, der i-ten Frequenzabtastung auf dem i-ten Teilspektrum, das dem nach der Verarbeitung erhaltenen analogen Signal entspricht, um ein entsprechendes erstes digitales Signal zu erhalten, Folgendes umfasst:

Durchführen (S702b), durch den Sender basierend auf der ersten Mittenfrequenz und der Phaseninformation des i-ten Teilspektrums, das dem nach der Verarbeitung erhaltenen Analogsignal entspricht, der i-ten Frequenzabtastung auf dem i-ten Teilspektrum, das dem nach der Verarbeitung erhaltenen Analogsignal entspricht, um ein entsprechendes Analogsignal zu erhalten; und
Durchführen (S702c), durch den Sender, einer Filterverarbeitung auf dem entsprechenden analogen Signal und Umwandeln des nach der Filterverarbeitung erhaltenen analogen Signals in das erste digitale Signal.

12. Verfahren nach Anspruch 11, wobei das Durchführen, durch den Sender basierend auf der ersten Mittenfrequenz und der Phaseninformation des i-ten Teilspektrums, das dem nach der Verarbeitung erhaltenen analogen Signal entspricht, der i-ten Frequenzabtastung auf dem i-ten Teilspektrum, das dem nach der Verarbeitung erhaltenen analogen Signal entspricht, Folgendes umfasst:

Bestimmen, durch den Sender, des i-ten Teilspektrums basierend auf der Phaseninformation des i-ten Teilspektrums, das dem nach der Verarbeitung erhaltenen Analogsignal entspricht; und
Durchführen, durch den Sender, einer Frequenzmodulation des i-ten Teilspektrums basierend auf der ersten Mittenfrequenz.

13. Verfahren nach einem der Ansprüche 9 bis 12, wobei das Verarbeiten des digitalen Basisbandsignals basierend auf der zweiten Mittenfrequenz zum Erhalten eines entsprechenden zweiten digitalen Signals Folgendes umfasst:
Durchführen (S703b), durch den Sender, einer Fourier-Transformation am digitalen Basisbandsignal basierend auf der zweiten Mittenfrequenz, Durchführen einer Filterverarbeitung an dem fourier-transformierten Signal und erneutes Durchführen einer Fourier-Transformation an dem nach der Filterverarbeitung erhaltenen Signal, um das zweite digitale Signal zu erhalten.

14. Verfahren nach Anspruch 13, wobei das Durchführen, durch den Sender, einer Fourier-Transformation an dem digitalen Basisbandsignal basierend auf der zweiten Mittenfrequenz, das Durchführen einer Filterverarbeitung an dem fourier-transformierten Signal und das erneute Durchführen einer Fourier-Transformation an dem nach der Filterverarbeitung erhaltenen Signal, um das zweite digitale Signal zu erhalten, Folgendes umfasst:

Berechnen, durch den Sender, des zweiten digitalen Signals mit Hilfe einer Formel $x'_i(k) = (lpf(x(k)*e^{j2\pi f_i(k)}*e^{-j2\pi f_i(k)})$, wobei
$x'_i(k)$ für das zweite digitale Signal steht, das der i-ten Frequenzabtastung in einem Prozess zur Berechnung des DPD-Koeffizienten zum k-ten Mal entspricht;
$x(k)$ für das digitale Basisbandsignal beim Prozess zum Berechnen des DPD-Koeffizienten zum k-ten Mal steht;
$lpf$ für eine digitale Tiefpassfilterfunktion steht; und
$f_i(k)$ für die zweite Mittenfrequenz beim Prozess zum Berechnen des DPD-Koeffizienten zum k-ten Mal steht, wobei k eine positive ganze Zahl größer oder gleich 1 ist.

15. Verfahren nach einem der Ansprüche 9 bis 14, wobei das Berechnen eines Fehlerwertes zwischen dem ersten und dem entsprechenden zweiten digitalen Signal durch den Sender und das Bestimmen eines DPD-Koeffizienten basierend auf den Fehlerwerten, die N Frequenzabtastungen entsprechen, Folgendes umfasst:

Berechnen, durch den Sender, eines Gesamtfehlerwertes mit Hilfe einer Formel $err(k) = \sum^N ((x'_i(k) - x_i(k)) * e^{j2\pi f_i(k)}$, wobei
$err(k)$ für den Gesamtfehlerwert beim Prozess zum Berechnen des DPD-Koeffizienten zum k-ten Mal steht;
$x'_i(k)$ für das zweite digitale Signal steht, das der i-ten Frequenzabtastung beim Prozess zum Berechnen des DPD-Koeffizienten zum k-ten Mal entspricht;
$x_i(k)$ für das erste digitale Signal steht, das der i-ten Frequenzabtastung beim Prozess zum Berechnen des DPD-Koeffizienten zum k-ten Mal entspricht;
$x'_i(k) - x_i(k)$ für den Fehlerwert steht, der der i-ten Frequenzabtastung beim Prozess zum Berechnen des DPD-Koeffizienten zum k-ten Mal entspricht; und
$f_i(k)$ für die zweite Mittenfrequenz beim Prozess zum Berechnen des DPD-Koeffizienten zum k-ten Mal steht, wobei k eine positive ganze Zahl größer oder gleich 1 ist; und
Berechnen, durch den Sender, des DPD-Koeffizienten zum k-ten Mal mit Hilfe einer Formel $a(k) = a(k-1) + \mu * err(k)\overline{x_i(k)}$, wo-

bei

*a(k)* für den DPD-Koeffizienten zum k-ten Mal steht;

*a(k-1)* für einen DPD-Koeffizienten zum (k-1)-ten Mal steht;

a(0)=(0);

$\mu$ für einen adaptiven Algorithmus-Aktualisierungsschritt steht; und

$\overline{x_i(k)}$ für ein Konjugat von $x_i(k)$ steht.

## Revendications

1. Emetteur (20), comprenant un dispositif de pré-distorsion numérique DPD (21), un module de transmission analogique (22), un module de rétroaction analogique (23) et un module de mise à jour de rétroaction DPD (24), dans lequel le module de mise à jour de rétroaction DPD (24) est connecté au dispositif DPD (23) ;

   le dispositif DPD (21) est configuré pour envoyer un signal numérique en bande de base au module de transmission analogique (22) et au module de mise à jour de rétroaction DPD (24) ;

   le module de transmission analogique (22) est configuré pour :

      traiter le signal numérique en bande de base pour obtenir un signal analogique, et envoyer le signal analogique obtenu après le traitement à une borne d'antenne et au module de rétroaction analogique (23) qui sont connectés au module de transmission analogique (22) ;

   le module de rétroaction analogique (23) est configuré pour :

      recevoir un i<sup>ème</sup> mot de commande de fréquence envoyé par le module de mise à jour de rétroaction DPD (24) ;

      déterminer, sur la base du i<sup>ème</sup> mot de commande de fréquence, une première fréquence centrale d'un i<sup>ème</sup> balayage de fréquence et des informations de phase d'un i<sup>ème</sup> sous-spectre correspondant au signal analogique obtenu après le traitement ;

      effectuer, sur la base de la première fréquence centrale et des informations de phase du i<sup>ème</sup> sous-spectre correspondant au signal analogique obtenu après le traitement, le i<sup>ème</sup> balayage de fréquence sur le i<sup>ème</sup> sous-spectre correspondant au signal analogique obtenu après le traitement, pour obtenir un premier signal numérique correspondant ; et

      envoyer le premier signal numérique au module de mise à jour de rétroaction DPD (24), dans lequel le i<sup>ème</sup> balayage de fréquence

est un balayage de fréquence effectué par le module de rétroaction analogique (23) sur le i<sup>ème</sup> sous-spectre correspondant au signal analogique obtenu après le traitement, i=1, 2, ... et N, et N est une quantité de sous-spectres compris dans un spectre du signal analogique obtenu après le traitement ;

   le module de mise à jour de rétroaction DPD (24) est configuré pour :

      déterminer une seconde fréquence centrale sur la base du i<sup>ème</sup> mot de commande de fréquence, de sorte que la première fréquence centrale soit alignée avec la seconde fréquence centrale ;

      traiter le signal numérique en bande de base sur la base de la seconde fréquence centrale pour obtenir un second signal numérique correspondant ;

      calculer une valeur d'erreur entre le premier signal numérique et le second signal numérique correspondant ;

      déterminer un coefficient DPD sur la base des valeurs d'erreur correspondant à N balayages de fréquence ; et

      envoyer le coefficient DPD au dispositif DPD (21) ; et

   le dispositif DPD (21) est en outre configuré pour :

      calibrer le signal numérique en bande de base sur la base du coefficient DPD, et envoyer le signal calibré au module de transmission analogique (22) et au module de mise à jour de rétroaction DPD (24) en tant que nouveau signal numérique en bande de base.

2. Emetteur (20) selon la revendication 1, dans lequel le module de transmission analogique comprend un convertisseur numérique-analogique (221), un premier mélangeur de fréquence (222), un amplificateur (223) et un premier oscillateur local (224), dans lequel le convertisseur numérique-analogique (221) est configuré pour :

      convertir le signal numérique en bande de base en un signal analogique en bande de base, et envoyer le signal analogique en bande de base au premier mélangeur de fréquence (222) ;

   le premier oscillateur local (224) est configuré pour :

      générer un signal de fréquence locale et envoyer le signal de fréquence locale au premier mélangeur de fréquence (222) ;

   le premier mélangeur de fréquence (222) est configuré pour :

effectuer une modulation de fréquence sur le signal analogique en bande de base sur la base du signal de fréquence locale, et envoyer le signal analogique modulé en fréquence à l'amplificateur (223) ; et

l'amplificateur (223) est configuré pour :

amplifier le signal analogique modulé en fréquence pour obtenir le signal analogique obtenu après le traitement, et envoyer le signal analogique obtenu après le traitement à une antenne et au module de rétroaction analogique qui sont connectés au module de transmission analogique (22).

3. Emetteur (22) selon la revendication 1 ou 2, dans lequel le module de rétroaction analogique comprend un second oscillateur local (231), un deuxième mélangeur de fréquence (232), un premier filtre (233) et un convertisseur analogique-numérique (234), dans lequel le second oscillateur local (231) est configuré pour :

recevoir le $i^{ème}$ mot de commande de fréquence envoyé par le module de mise à jour de rétroaction DPD (24) ;

déterminer, sur la base du $i^{ème}$ mot de commande de fréquence, la première fréquence centrale et les informations de phase du $i^{ème}$ sous-spectre correspondant au signal analogique obtenu après le traitement ; et

envoyer, au deuxième mélangeur de fréquence (232), la première fréquence centrale et les informations de phase du $i^{ème}$ sous-spectre correspondant au signal analogique obtenu après le traitement ;

le deuxième mélangeur de fréquence (232) est configuré pour :

recevoir le signal analogique obtenu après le traitement ;

effectuer, sur la base de la première fréquence centrale et des informations de phase du $i^{ème}$ sous-spectre correspondant au signal analogique obtenu après le traitement, le $i^{ème}$ balayage de fréquence sur le $i^{ème}$ sous-spectre correspondant au signal analogique obtenu après le traitement, pour obtenir un signal analogique correspondant ; et

envoyer le signal analogique correspondant au premier filtre (233) ;

le premier filtre (233) est configuré pour :

effectuer un traitement de filtrage sur le signal analogique correspondant, et envoyer le signal analogique obtenu après le traitement de filtrage au convertisseur analogique-numérique (234) ; et

le convertisseur analogique-numérique (234) est configuré pour :

convertir le signal analogique obtenu après le traitement de filtrage en premier signal numérique, et envoyer le premier signal numérique au module de mise à jour de rétroaction DPD (24).

4. Emetteur (20) selon la revendication 3, dans lequel le deuxième mélangeur de fréquence (232) est spécifiquement configuré pour :

déterminer le $i^{ème}$ sous-spectre sur la base des informations de phase du $i^{ème}$ sous-spectre correspondant au signal analogique obtenu après le traitement ; et

effectuer une modulation de fréquence sur le $i^{ème}$ sous-spectre sur la base de la première fréquence centrale.

5. Emetteur (20) selon l'une quelconque des revendications 1 à 4, dans lequel le module de mise à jour de rétroaction DPD (24) comprend une unité de transformation (241), un processeur (242) et un additionneur (243), dans lequel le processeur (242) est configuré pour :

générer la seconde fréquence centrale sur la base du $i^{ème}$ mot de commande de fréquence, et envoyer la seconde fréquence centrale à l'unité de transformation (241) ;

l'unité de transformation (241) est configurée pour :

recevoir le signal numérique en bande de base ;

effectuer une transformée de Fourier sur le signal numérique en bande de base sur la base de la seconde fréquence centrale ;

effectuer un traitement de filtrage sur le signal soumis à la transformée de Fourier ;

effectuer de nouveau une transformée de Fourier sur le signal obtenu après le traitement de filtrage, pour obtenir le second signal numérique ; et

envoyer le second signal numérique à l'additionneur (243) ;

l'additionneur (243) est configuré pour :

calculer la valeur d'erreur entre le premier signal numérique et le second signal numérique correspondant, et envoyer, au processeur (242), les valeurs d'erreur correspondant aux N balayages de fréquence ; et

le processeur (242) est en outre configuré pour :

déterminer le coefficient DPD sur la base des valeurs d'erreur correspondant aux N balayages de fréquence, et envoyer le coefficient DPD au dispositif DPD (21).

6. Emetteur (20) selon la revendication 5, dans lequel l'unité de transformation (241) est spécifiquement configurée pour :

calculer le second signal numérique à l'aide d'une formule $x'_i(k) = (lpf(x(k) * e^{j2\pi f_i(k)}) * e^{-j2\pi f_i(k)})$, dans laquelle

$x'_i(k)$ représente le second signal numérique correspondant au $i^{ème}$ balayage de fréquence dans un processus de calcul du coefficient DPD pendant une $k^{ème}$ fois ;

$x(k)$ représente le signal numérique en bande de base dans le processus de calcul du coefficient DPD pour la $k^{ème}$ fois ;

$lpf$ représente une fonction de filtrage passe-bas numérique ; et

$f_i(k)$ représente la seconde fréquence centrale dans le processus de calcul du coefficient DPD pour la $k^{ème}$ fois, $k$ étant un entier positif supérieur ou égal à 1.

7. Emetteur (20) selon la revendication 5 ou 6, dans lequel l'unité de transformation (241) comprend un troisième mélangeur de fréquence (2411), un second filtre (2412) et un quatrième mélangeur de fréquence (2413), dans lequel le troisième mélangeur de fréquence (2411) est configuré pour :

recevoir le signal numérique en bande de base et effectuer une transformée de Fourier sur le signal numérique en bande de base sur la base de la seconde fréquence centrale pour obtenir le signal soumis à la transformée de Fourier ;

le second filtre (2412) est configuré pour effectuer un traitement de filtrage sur le signal soumis à la transformée de Fourier ; et

le quatrième mélangeur de fréquence (2413) est configuré pour :

effectuer de nouveau une transformée de Fourier sur le signal obtenu après le traitement de filtrage, pour obtenir le second signal numérique ; et

envoyer le second signal numérique à l'additionneur (243).

8. Emetteur (20) selon l'une quelconque des revendications 5 à 7, dans lequel le processeur (242) est spécifiquement configuré pour :

calculer une valeur d'erreur totale à l'aide d'une formule $err(k) = \sum^N ((x'_i(k) - x_i(k)) * e^{j2\pi f_i(k)}$, dans laquelle

$err(k)$ représente la valeur d'erreur totale dans le processus de calcul du coefficient DPD pour la $k^{ème}$ fois ;

$x'_i(k)$ représente le second signal numérique correspondant au $i^{ème}$ balayage de fréquence dans le processus de calcul du coefficient DPD pour la $k^{ème}$ fois ;

$x_i(k)$ représente le premier signal numérique correspondant au $i^{ème}$ balayage de fréquence dans le processus de calcul du coefficient DPD pour la $k^{ème}$ fois ;

$x'_i(k) - x_i(k)$ représente la valeur d'erreur correspondant au $i^{ème}$ balayage de fréquence dans le processus de calcul du coefficient DPD pour la $k^{ème}$ fois ; et

$f_i(k)$ représente la seconde fréquence centrale dans le processus de calcul du coefficient DPD pour la $k^{ème}$ fois, $k$ étant un entier positif supérieur ou égal à 1 ; et

calculer le coefficient DPD pour la $k^{ème}$ fois à l'aide d'une formule $a(k) = a(k-1) + \mu * err(k)\overline{x_i(k)}$, dans laquelle

$a(k)$ représente le coefficient DPD pour la $k^{ème}$ fois ;

$a(k-1)$ représente un coefficient DPD pour une $(k-1)^{ème}$ fois ;

$a(0)=0$ ;

$\mu$ représente une étape de mise à jour d'algorithme adaptatif ; et

$\overline{x_i(k)}$ représente un conjugué de $x_i(k)$.

9. Procédé d'étalonnage de pré-distorsion numérique, comprenant :

le traitement (S701), par un émetteur, d'un signal numérique en bande de base pour obtenir un signal analogique, et la sortie du signal analogique obtenu après le traitement à une borne d'antenne de l'émetteur ;

la détermination (S702), par l'émetteur sur la base d'un $i^{ème}$ mot de commande de fréquence, d'une première fréquence centrale d'un $i^{ème}$ balayage de fréquence et des informations de phase d'un $i^{ème}$ sous-spectre correspondant au signal analogique obtenu après le traitement ; et

la réalisation, sur la base de la première fréquence centrale et des informations de phase du $i^{ème}$ sous-spectre correspondant au signal analogique obtenu après le traitement, du $i^{ème}$ balayage de fréquence sur le $i^{\text{ème}}$ sous-spectre correspondant au signal analogique obtenu après le traitement, pour obtenir un premier signal numérique correspondant, le $i^{\text{ème}}$ balayage de fréquence étant un balayage de fréquence effectué par le module de rétroaction analogique sur le $i^{\text{ème}}$ sous-spectre correspondant au signal analogique obtenu après le traitement, i=1, 2, ..., et N, et N est une quantité de sous-spectres compris dans un spectre du signal analogique obtenu après le traitement ;

la détermination (S703), par l'émetteur, d'une seconde fréquence centrale sur la base du $i^{\text{ème}}$ mot de commande de fréquence, de sorte que la première fréquence centrale soit alignée avec la seconde fréquence centrale ; et

le traitement du signal numérique en bande de base sur la base de la seconde fréquence centrale pour obtenir un second signal numérique correspondant ; et

Lle calcul (S704), par l'émetteur, d'une valeur d'erreur entre le premier signal numérique et le second signal numérique correspondant ;j la détermination d'un coefficient DPD sur la base des valeurs d'erreur correspondant à N balayages de fréquence ;

l'étalonnage du signal numérique en bande de base sur la base du coefficient DPD ; et

la réalisation d'un traitement, identique à celui du signal numérique en bande de base, sur le signal étalonné qui est utilisé en tant que nouveau signal numérique en bande de base.

10. Procédé selon la revendication 9, dans lequel le traitement (S701), par un émetteur, d'un signal numérique en bande de base pour obtenir un signal analogique comprend :

la conversion (S701a), par l'émetteur, du signal numérique en bande de base en un signal analogique en bande de base ;

la génération (S701b), par l'émetteur, d'un signal de fréquence locale ; et

la réalisation (S701c), par l'émetteur, d'une modulation de fréquence sur le signal analogique de bande de base sur la base du signal de fréquence locale, et l'amplification du signal analogique modulé en fréquence pour obtenir le signal analogique obtenu après le traitement.

11. Procédé selon la revendication 9 ou 10, dans lequel la réalisation (S701c), sur la base de la première fréquence centrale et des informations de phase du $i^{\text{ème}}$ sous-spectre correspondant au signal analogique obtenu après le traitement, du $i^{\text{ème}}$ balayage de fréquence sur le $i^{\text{ème}}$ sous-spectre correspondant au signal analogique obtenu après le traitement, pour obtenir un premier signal numérique correspondant comprend :

la réalisation (S702b), par l'émetteur sur la base de la première fréquence centrale et des informations de phase du $i^{\text{ème}}$ sous-spectre correspondant au signal analogique obtenu après le traitement, du $i^{\text{ème}}$ balayage de fréquence sur le $i^{\text{ème}}$ sous-spectre correspondant au signal analogique obtenu après le traitement, pour obtenir un signal analogique correspondant ; et

la réalisation (S702c), par l'émetteur, d'un traitement de filtrage sur le signal analogique correspondant, et la conversion du signal analogique obtenu après le traitement de filtrage en premier signal numérique.

12. Procédé selon la revendication 11, dans lequel la réalisation, par l'émetteur sur la base de la première fréquence centrale et des informations de phase du $i^{\text{ème}}$ sous-spectre correspondant au signal analogique obtenu après le traitement, du $i^{\text{ème}}$ balayage de fréquence sur le $i^{\text{ème}}$ sous-spectre correspondant au signal analogique obtenu après le traitement comprend :

la détermination, par l'émetteur, du $i^{\text{ème}}$ sous-spectre sur la base des informations de phase du $i^{\text{ème}}$ sous-spectre correspondant au signal analogique obtenu après le traitement ; et

la réalisation, par l'émetteur, d'une modulation de fréquence sur le $i^{\text{ème}}$ sous-spectre sur la base de la première fréquence centrale.

13. Procédé selon l'une quelconque des revendications 9 à 12, dans lequel le traitement du signal numérique en bande de base sur la base de la seconde fréquence centrale pour obtenir un second signal numérique correspondant comprend :

la réalisation (S703b), par l'émetteur, d'une transformée de Fourier sur le signal numérique en bande de base sur la base de la seconde fréquence centrale, la réalisation d'un traitement de filtrage sur le signal soumis à la transformée de Fourier, et la réalisation d'une transformée de Fourier de nouveau sur le signal obtenu après le traitement de filtrage, pour obtenir le second signal numérique.

14. Procédé selon la revendication 13, dans lequel la réalisation, par l'émetteur, d'une transformée de Fourier sur le signal numérique en bande de base sur la base de la seconde fréquence centrale, la réalisation d'un traitement de filtrage sur le signal soumis à la transformée de Fourier, et la réalisation de la transformée de Fourier de nouveau sur le signal obtenu après le traitement de filtrage, pour obtenir le second signal numérique, comprend :

Le calcul, par l'émetteur, du second signal numérique à l'aide d'une formule $x'_i(k) =$ $(lpf(x(k)*e^{j2\pi f_i(k)}*e^{-j2\pi f_i(k)}$, dans laquelle

$x'_i(k)$ représente le second signal numérique correspondant au $i^{\text{ème}}$ balayage de fréquence dans un processus de calcul du coefficient DPD pendant une k-$^{\text{ème}}$ fois ;

x(k) représente le signal numérique en bande de base dans le processus de calcul du coefficient DPD pour la k-$^{\text{ème}}$ fois ;

$lpf$ représente une fonction de filtrage passe-bas numérique ; et

$f_i(k)$ représente la seconde fréquence centrale dans le processus de calcul du coefficient DPD pour la k-$^{\text{ème}}$ fois, k étant un entier positif supérieur ou égal à 1.

**15.** Procédé selon l'une quelconque des revendications 9 à 14, dans lequel le calcul, par l'émetteur, d'une valeur d'erreur entre le premier signal numérique et le second signal numérique correspondant, et la détermination d'un coefficient DPD sur la base des valeurs d'erreur correspondant à N balayages de fréquence comprend :

le calcul, par l'émetteur, d'une valeur d'erreur totale à l'aide d'une formule $err(k) =$ $\sum^N ((x'_i(\text{k}) - x_i(\text{k})) * e^{j2\pi f_i(k)}$, dans laquelle

$err(k)$ représente la valeur d'erreur totale dans le processus de calcul du coefficient DPD pour la k-$^{\text{ème}}$ fois ;

$x'_i(k)$ représente le second signal numérique correspondant au $i^{\text{ème}}$ balayage de fréquence dans le processus de calcul du coefficient DPD pour la k-$^{\text{ème}}$ fois ;

$x_i(k)$ représente le premier signal numérique correspondant au $i^{\text{ème}}$ balayage de fréquence dans le processus de calcul du coefficient DPD pour la k-$^{\text{ème}}$ fois ;

$x'_i(k) - x_i(k)$ représente la valeur d'erreur correspondant au $i^{\text{ème}}$ balayage de fréquence dans le processus de calcul du coefficient DPD pour la k-$^{\text{ème}}$ fois ; et

$f_i(k)$ représente la seconde fréquence centrale dans le processus de calcul du coefficient DPD pour la k-$^{\text{ème}}$ fois, k étant un entier positif supérieur ou égal à 1 ; et

le calcul, par l'émetteur, du coefficient DPD pour la k-$^{\text{ème}}$ fois à l'aide d'une formule $a(k) =$ $a(k-1) + \mu * err(k)\overline{x_i(k)}$, dans laquelle

$a(k)$ représente le coefficient DPD pour la k-$^{\text{ème}}$ fois ;

$a(k-1)$ représente un coefficient DPD pour une (k-1)-$^{\text{ème}}$ fois ;

a(0)=(0) ;

$\mu$ représente une étape de mise à jour d'algorithme adaptatif ; et

$\overline{x_i(k)}$ représente un conjugué de $x_i(k)$.

10

Feedback module
Entire bandwidth
occupied by the power
amplifier output signal

Spectrum of a power
amplifier output signal

LO1

LO2

−2.5 * Signal    +2.5 * Signal
bandwidth          bandwidth

ADC

11          12          13          14          15          16          17

FIG. 1

20

Transmitter

Input a digital
baseband signal

21

DPD device

22

Analog
transmission
module

DPD feedback
updating module

Analog feedback
module

24          23

FIG. 2

**FIG. 3**

**FIG. 4**

FIG. 5

FIG. 6

A transmitter processes a digital baseband signal to obtain an analog signal, and outputs the analog signal obtained after the processing to an antenna terminal of the transmitter — S701

The transmitter determines, based on an $i^{th}$ frequency control word, a first center frequency of an $i^{th}$ frequency scan and phase information of an $i^{th}$ sub-spectrum corresponding to the analog signal obtained after the processing; and performs, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding first digital signal — S702

The transmitter determines a second center frequency based on the $i^{th}$ frequency control word, so that the first center frequency is aligned with the second center frequency; and processes the digital baseband signal based on the second center frequency to obtain a corresponding second digital signal — S703

The transmitter calculates an error value between the first digital signal and the corresponding second digital signal; determines a DPD coefficient based on error values corresponding to N frequency scans; calibrates the digital baseband signal based on the DPD coefficient; and performs processing, the same as that on the digital baseband signal, on the calibrated signal that is used as a new digital baseband signal — S704

FIG. 7

A transmitter converts a digital baseband signal into an analog baseband signal — S701a

The transmitter generates a local-frequency signal — S701b

The transmitter performs frequency modulation on the analog baseband signal based on the local-frequency signal, amplifies the frequency-modulated analog signal to obtain an analog signal obtained after processing, and outputs the analog signal obtained after the processing to an antenna terminal of the transmitter — S701c

The transmitter determines, based on an $i^{th}$ frequency control word, a first center frequency of an $i^{th}$ frequency scan and phase information of an $i^{th}$ sub-spectrum corresponding to the analog signal obtained after the processing — S702a

The transmitter performs, based on the first center frequency and the phase information of the $i^{th}$ sub-spectrum corresponding to the analog signal obtained after the processing, the $i^{th}$ frequency scan on the $i^{th}$ sub-spectrum corresponding to the analog signal obtained after the processing, to obtain a corresponding analog signal — S702b

The transmitter performs filtering processing on the corresponding analog signal, and converts the analog signal obtained after the filtering processing into a first digital signal — S702c

The transmitter determines a second center frequency based on the $i^{th}$ frequency control word, so that the first center frequency is aligned with the second center frequency — S703a

The transmitter performs Fourier transform on the digital baseband signal based on the second center frequency, performs filtering processing on the Fourier-transformed signal, and performs Fourier transform again on the signal obtained after the filtering processing, to obtain a second digital signal — S703b

The transmitter calculates an error value between the first digital signal and the corresponding second digital signal; determines a DPD coefficient based on error values corresponding to N frequency scans; calibrates the digital baseband signal based on the DPD coefficient; and performs processing, the same as that on the digital baseband signal, on the calibrated signal that is used as a new digital baseband signal — S704

FIG. 8

**EP 3 531 644 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1560327 A1

- US 20070241812 A1